# EUROPEAN PATENT APPLICATION

(11) **EP 3 225 338 A1**
(43) Date of publication of application: **04.10.2017**
(21) Application number: 15863164.8
(22) Date of filing: 27.11.2015
(51) Int. Cl.: B23B 27/14

(54) **SURFACE-COATED CUTTING TOOL**

(30) Priority: 28.11.2014 JP 2014240834; 25.11.2015 JP 2015229738
(71) Applicant: Mitsubishi Materials Corporation, Chiyoda-ku Tokyo 100-8117 (JP)
(72) Inventor: SATO Kenichi, Naka-shi Ibaraki 311-0102 (JP); TATSUOKA Sho, Naka-shi Ibaraki 311-0102 (JP); YAMAGUCHI Kenji, Naka-shi Ibaraki 311-0102 (JP)
(74) Representative: Gille Hrabal
(86) International application number: PCT/JP2015/083400
(87) International publication number: WO 2016/084938

(57) **Abstract**

A surface-coated cutting tool with a hard coating layer is provided. The hard coating layer includes at least a complex nitride or carbonitride layer (2) expressed by a composition formula: (Ti_{l-x-y}AlₓMe_{y})(CN_{l-z}), Me being an element selected from Si, Zr, B, V, and Cr. The average content ratio X_{avg}, the average content ratio Y_{avg}, and the average content ratio Z_{avg} satisfy 0.60≤X_{avg}, 0.005≤Y_{avg}≤0.10, 0≤Z_{avg}≤0.005, and 0.605≤X_{avg}+ Y_{avg} ≤0.95. There are crystal grains having a cubic structure in the crystal grains constituting the complex nitride or carbonitride layer (2). A predetermined periodic content ratio change of Ti, Al and Me exists in the crystal grains having the cubic structure.

## Description

### TECHNICAL FIELD

The present invention relates to a surface coated cutting tool (hereinafter referred as "coated tool") that exhibits an excellent cutting performance for a long-term usage by having a hard coating layer with an excellent chipping resistance during high-speed intermittent cutting of alloy steel or the like in which high heat is generated and impacting load exerts on the cutting edge.

Priority is claimed on Japanese Patent Application No. 2014-240834, filed November 28, 2014, and Japanese Patent Application No. 2015-229738, filed November 25, 2015, the contents of which are incorporated herein by reference.

### BACKGROUND ART

Conventionally, the coated tools, in which as a hard coating layer, a Ti-Al-based complex nitride layer is formed on the surface of the body made of: tungsten carbide (hereinafter referred as WC) -based cemented carbide; titanium carbonitride (hereinafter referred as TiCN) -based cermet; or cubic boron nitride (hereinafter referred as cBN) -based ultra-high pressure sintered material (hereinafter collectively referred as "body"), by the physical vapor deposition method, are known. These coated tools exhibit an excellent wear resistance.

However, various proposals have been made for improving the hard coating layer since abnormal wear such as chipping or the like is prone to occur when coated tools, on which the conventional Ti-Al-based complex nitride layer is coated, are used in high-speed intermittent cutting condition, even though they exhibit relatively excellent wear resistance.

For example, in Patent Literature 1 (PTL 1), it is proposed to improve heat resistance and fatigue strength of coated tools by: providing a TiCN layer and an Al₂O₃ layer as inner layers; coating the inner layers by a (Ti₁₋ₓAlₓ)N layer (X being 0.65-0.9) having a cubic structure or a cubic structure including a hexagonal crystal structure as an outer layer by a chemical vapor deposition method; and providing compressive stress of 100-1100 MPa to the outer layer.

In addition, in Patent Literature 2 (PTL 2), it is disclosed that the wear resistance and the oxidation resistance of the hard coating layer are improved drastically in a surface-coated cutting tool including a tool body and a hard coating layer formed on the body by having the configuration in which the hard coating layer contains: a compound, which is made of: one element of or both elements of Al and Cr; at least an element selected from the group consisting of the elements belonging to 4a, 5a, and 6a in the periodic table, and Si; and at least an element selected from the group consisting of carbon, nitrogen, oxygen and boron; and chlorine.

In addition, it is described in Patent Literature 3 (PTL 3) that a (Ti₁₋ₓAlₓ)N layer, in which the Al content ratio x is 0.65-0.95, can be formed by performing a chemical vapor deposition in a temperature range of 650-900°C in a mixed reaction gas of TiCl₄, AlCl₃, and NH₃. What is intended in PTL 2 is improving heat insulating effect by putting an extra coating of the Al₂O₃ layer on top of the (Ti₁₋ₓAlₓ)N layer. Thus, PTL 2 is silent about any effect of forming the (Ti₁₋ₓAlₓ)N layer with the increased x value to 0.65-0.95 on the cutting performance itself.

### [Related Art Documents]

### [Patent Literature]

PTL 1: Published Japanese Translation No. 2011-513594 of the PCT International Publication (A)
PTL 2: Japanese Unexamined Patent Application, First Publication No. 2006-82207 (A)
PTL 3: Published Japanese Translation No. 2011-516722 of the PCT International Publication (A)

### DISCLOSURE OF INVENTION

### [Problems to be Solved by the Present Invention]

In recent years, there are strong demands for labor-saving and energy-saving in the cutting. In responding to the demands, there is a tendency that the cutting is performed at a higher speed and a higher efficiency. Thus, even higher abnormal resistance, such as chipping resistance, fracture resistance, peeling resistance, or the like, is required for a coated tool. At the same time, an excellent wear resistance for a long-term usage is required.

However, the coated tool described in PTL 1 has a predetermined hardness and an excellent wear resistance. However, its toughness is inferior. Thus, in the case where it is applied to high-speed intermittent cutting of alloy steel or the like, abnormal damage, such as chipping, fracture, peeling, and the like, is prone to occur. Accordingly, there is a technical problem that the coated cutting tool described in PTL 1 does not exhibit a satisfactory cutting performance.

In addition, in the coated tool described in PTL 2, improvement of the wear resistance and the oxidation resistance is intended. However, it has the technical problem that the chipping resistance is not sufficient in the cutting condition accompanied with impacts such as in the high-speed intermittent cutting and the like.

On the other hand, in the deposited (Ti₁₋ₓAlₓ)N layer by the chemical vapor deposition method in PTL 3, the Al content x can be increased; and the cubic crystal structure can be formed. Thus, the hard coating layer having a predetermined hardness and excellent wear resistance can be obtained. However, it has the technical problem that the adhesive strength of the hard coating layer to the body is not sufficient; and the toughness is inferior.

The technical problem to be solved by the present invention, which is the purpose of the present invention, is to provide a coated tool that exhibits: an excellent toughness; an excellent chipping resistance; and an excellent wear resistance, for a long-term usage even if the coated tool is applied to high-speed intermittent cutting of alloy steel, carbon steel, cast iron, or the like.

### [Means to Solving the Problems]

In the light of the above-described viewpoint, the inventors of the present invention conducted an intensive study to improve chipping resistance and wear resistance of the coated tool on which a hard coating layer including at least an Al and Ti complex nitride or complex carbonitride (occasionally referred as "(Ti, Al)(C,N)" or "(Ti₁₋ₓAlₓ)(C_{y}N_{1-y})") is formed. Then they obtained findings described below.

In the conventionally known hard coating layer, at least one (Ti₁₋ₓAlₓ)(C_{y}N_{1-y}) layer with a predetermined average layer thickness is included. In addition, the (Ti₁₋ₓAlₓ)(C_{y}N_{1-y}) layer is formed in a columnar crystal structure along with the direction perpendicular to the surface of the tool body. In this case, the surface coated cutting tool with the conventional hard coating layer obtains a high wear resistance. On the other hand, the higher the anisotropy in the crystal structure of the (Ti₁₋ₓAlₓ)(C_{y}N_{1-y}) layer, the lower the toughness of the (Ti₁₋ₓAlₓ)(C_{y}N_{1-y}) layer. As a result, chipping resistance and fracture resistance of the surface coated cutting tool decrease, making it impossible for the coated tool to exhibit a sufficient wear resistance for long-term usage. Also, the length of the tool life is not satisfactory.

Under the circumstances described above, the inventors of the present invention conducted an intensive study on the (Ti₁₋ₓAlₓ)(C_{y}N_{1-y}) layer which is a constituent of the hard coating layer. Then, they succeeded to improve hardness and toughness of the hard coating layer by introducing strain in cubic crystal grains based on the entirely novel idea, in which an element selected from Si, Zr, B, V, and Cr (hereinafter, referred as "Me") is included in the hard coating layer; the (Ti_{1-x-y}AlₓMe_{y})(C_{z}N_{1-z}) layer is mainly constituted from crystal grains having a NaCl type face-centered cubic structure; and a periodic content ratio change of Ti, Al and Me (content ratio) is formed in the cubic crystal phase. As a result, they found that a novel finding that the chipping resistance and the fracture resistance of the hard coating layer can be improved.

Specifically, the surface coated cutting tool has a hard coating layer including at least a Ti, Al and Me complex nitride or carbonitride layer having an average layer thickness of 1 µm to 20 µm, Me being an element selected from Si, Zr, B, V, and Cr, in a case where a composition of the complex nitride or carbonitride layer is expressed by a composition formula: (Ti_{1-x-y}AlₓMe_{y})(C_{z}N_{1-z}), an average content ratio X_{avg}, which is a ratio ofAl to a total amount of Ti, Al and Me; an average content ratio Y_{avg}, which is a ratio of Me to the total amount of Ti, Al and Me; and an average content ratio Z_{avg}, which is a ratio of C to a total amount of C and N, satisfy 0.60≤X_{avg}, 0.005≤Y_{avg}≤0.10, 0≤Z_{avg}≤0.005, and 0.605≤X_{avg}+ Y_{avg} ≤0.95, provided that each of X_{avg}, Y_{avg} and Z_{avg} is in atomic ratio, the complex nitride or carbonitride layer includes at least a phase of Ti, Al and Me complex nitride or carbonitride having a NaCl type face-centered cubic structure, when crystal orientations of crystal grains of the Ti, Al and Me complex nitride or carbonitride having the NaCl type face-centered cubic structure in the complex nitride or carbonitride layer are analyzed from a vertical cross sectional direction with an electron beam backward scattering diffraction device, inclined angles of normal lines of {111} planes, which are crystal planes of the crystal grains, relative to an direction of a normal line of the surface of the tool body are measured, and an inclined angle frequency distribution is obtained by tallying frequencies present in each section after dividing inclined angles into sections in every 0.25° pitch in a range of 0 to 45° relative to the direction of the normal line among the inclined angles, a highest peak is present in an inclined angle section in a range of 0° to 12°, a ratio of a sum of frequencies in the range of 0° to 12° to an overall frequency in the inclined angle frequency distribution is 35% or more, a periodic content ratio change of Ti, Al and Me in the composition formula: (Ti_{1-x-y}AlₓMe_{y})(C_{z}N_{1-z} exists in the crystal grains of the Ti, Al and Me complex nitride or carbonitride having the NaCl type face-centered cubic structure, a difference Δx between Xₘₐₓ and Xₘᵢₙ is 0.03 to 0.25, Xₘₐₓ and Xₘᵢₙ being an average value of local maximums of the periodically fluctuating Al content x and an average value of local minimums of the periodically fluctuating Al content x, respectively, and a period along the direction of the normal line of the surface of the tool body is 3 nm to 100 nm in the crystal grains, in which the periodic content ratio change of Ti, Al and Me exists, having the NaCl type face-centered cubic structure in the complex nitride or carbonitride layer. The inventors of the present invention found that by having the configurations described above: strain is introduced in the crystal grains having the NaCl type face-centered cubic structure; hardness and toughness of the (Ti_{1-x-y}AlₓMe_{y})(C_{z}N_{1-z}) layer are improved compared to the conventional hard coating layer; the chipping resistance and the fracture resistance of the hard coating layer are improved eventually; and the coated tool exhibits an excellent wear resistance for a long-term usage.

For example, the (Ti_{1-x-y}AlₓMe_{y})(C_{z}N_{1-z}) layer as configured above can be deposited by the chemical vapor deposition method explained below, in which the reaction gas composition is changed periodically on the surface of the tool body.

To the chemical vapor deposition reaction apparatus used, each of the gas group A, which is made of NH₃, N₂ and H₂, and the gas group B, which is made of TiCl₄, Al(CH₃)₃, AlCl₃, MeClₙ (chloride of Me), NH₃, N₂, and H₂, is supplied through independent gas supplying pipes leading in the reaction apparatus. The gas groups A and B are supplied in the reaction apparatus in such a way that the gas flows only in a shorter time than a specific period in a constant time interval in a constant period, for example. In this way, phase difference with the shorter time than the gas supplying time is formed in the gas supply of the gas groups A and B. Accordingly, the composition of the reaction gas on the surface of the tool body can be changed temporally, such as: (I) the gas group A; (II) the mixed gas of the gas groups A and B; and (III) the gas group B. In the present invention, there is no need to provide a long term exhausting process intending strict gas substitution. Thus, the temporal change of the composition of the reaction gas on the surface of the tool body can be changed among: (I) a mixed gas, the major component of which is the gas group A; (II) the mixed gas of the gas groups A and B; and (III) a mixed gas, the major component of which is the gas group B by: rotating the gas supply ports; rotating the tool bodies; or moving the tool body reciprocally as the gas supplying method, for example.

The (Ti_{1-x-y}AlₓMe_{y})(C_{z}N_{1-z}) layer having a predetermined intended layer thickness is deposited, for example, by performing the thermal CVD method for a predetermined time on the surface of the tool body in the condition of: the gas group A including 1.0% to 1.5% of NH₃, 0% to 5% of N₂ and 55% to 60% of H₂; the gas group B including 0.6% to 0.9% of AlCl₃, 0.2% to 0.3% of TiCl₄, 0.1% to 0.2% of MeClₙ (chloride of Me); 0% to 0.5% of Al(CH₃)₃,0.0% to 12.0% of N₂, and balance H₂; the pressure of the reaction atmosphere being 4.5kPa to 5.0kPa; the temperature of the reaction atmosphere being 700°C-900°C; the supply period being 1 second to 5 seconds; the gas supply time per one period being 0.15 second to 0.25 second; and the phase difference of the gas supply of the gas groups A and B being 0.10 second to 0.20 second.

By supplying the gas groups A and B in such a way that each of the gas groups A and B reach to the surface of the tool body in different timings with time difference as explained above; and by configuring the nitrogen raw material gas of the gas group A to 1.0% to 1.5% of NH₃ and 0% to 5% of N₂, and the metal chloride material gas or carbon material gas of the gas group B to 0.6% to 0.9% of AlCl₃, 0.2% to 0.3% of TiCl₄, 0.1% to 0.2% of MeClₙ (chloride of Me), and 0% to 0.5% of Al(CH₃)₃, unevenness of the composition in the crystal grains and local strains of the crystal lattice by introduction of dislocation or point defect are formed. In addition, the extent of the {111} orientation of the crystal grains on the surface side of the tool body and the surface side of the coating film can be varied. As a result, the inventors found that the toughness is improved drastically while the wear resistance is retained. As a result, they found that fracture resistance and chipping resistance are improved particularly; and the hard coating layer exhibits excellent cutting performance for a long-term used even in high-speed intermittent cutting of alloy steel or the like, in which intermittent and impact load is exerted on the cutting edge.

The present invention is made based on the above-described findings, and has aspects below.
(1) A surface coated cutting tool including: a tool body made of any one of tungsten carbide-based cemented carbide, titanium carbonitride-based cermet, and cubic boron nitride-based ultra-high pressure sintered material; and a hard coating layer formed on a surface of the tool body, wherein
   (a) the hard coating layer includes at least a Ti, Al and Me complex nitride or carbonitride layer having an average layer thickness of 1 µm to 20 µm, Me being an element selected from Si, Zr, B, V, and Cr,
      in a case where a composition of the complex nitride or carbonitride layer is expressed by a composition formula: (Ti_{1-x-y}AlₓMe_{y})(C_{z}N_{1-z}), an average content ratio X_{avg}, which is a ratio of Al to a total amount of Ti, Al and Me; an average content ratio Y_{avg}, which is a ratio of Me to the total amount of Ti, Al and Me; and an average content ratio Z_{avg}, which is a ratio of C to a total amount of C and N, satisfy 0.60≤X_{avg}, 0.005≤Y_{avg}≤0.10, 0≤Z_{avg}≤0.005, and 0.605≤X_{avg}+ Y_{avg} ≤0.95, provided that each of X_{avg}, Y_{avg} and Z_{avg} is in atomic ratio,
   (b) the complex nitride or carbonitride layer includes at least a phase of Ti, Al and Me complex nitride or carbonitride having a NaCl type face-centered cubic structure,
   (c) when crystal orientations of crystal grains of the Ti, Al and Me complex nitride or carbonitride having the NaCl type face-centered cubic structure in the complex nitride or carbonitride layer are analyzed from a vertical cross sectional direction with an electron beam backward scattering diffraction device, inclined angles of normal lines of {111} planes, which are crystal planes of the crystal grains, relative to an direction of a normal line of the surface of the tool body are measured, and an inclined angle frequency distribution is obtained by tallying frequencies present in each section after dividing inclined angles into sections in every 0.25° pitch in a range of 0 to 45° relative to the direction of the normal line among the inclined angles,
      a highest peak is present in an inclined angle section in a range of 0° to 12°, a ratio of a sum of frequencies in the range of 0° to 12° to an overall frequency in the inclined angle frequency distribution is 35% or more,
   (d) a periodic content ratio change of Ti, Al and Me in the composition formula: (Ti_{1-x-y}AlₓMe_{y})(C_{z}N_{1-z} exists in the crystal grains of the Ti, Al and Me complex nitride or carbonitride having the NaCl type face-centered cubic structure,
      a difference Δx between Xₘₐₓ and Xₘᵢₙ is 0.03 to 0.25, Xₘₐₓ and Xₘᵢₙ being an average value of local maximums of the periodically fluctuating Al content x and an average value of local minimums of the periodically fluctuating Al content x, respectively, and
   (e) a period along the direction of the normal line of the surface of the tool body is 3 nm to 100 nm in the crystal grains, in which the periodic content ratio change of Ti, Al and Me exists, having the NaCl type face-centered cubic structure in the complex nitride or carbonitride layer.
(2) The surface coated cutting tool according to the above-described (1), wherein
   in the crystal grains, in which the periodic content ratio change of Ti, Al and Me exists, having the NaCl type face-centered cubic structure in the complex nitride or carbonitride layer,
   the periodic content ratio change of Ti, Al and Me is aligned along with an orientation belonging to equivalent crystal orientations expressed by <001> in a cubic crystal grain, a period along the orientation is 3 nm to 100 nm, and a maximum ΔXo of a change of content ratio x ofAl in a plane perpendicular to the orientation is 0.01 or less.
(3) The surface coated cutting tool according to the above-described (1), wherein
   in the crystal grains, in which the periodic content ratio change of Ti, Al and Me exists, having the NaCl type face-centered cubic structure in the complex nitride or carbonitride layer,
   a region A and a region B exist in the crystal grains; and
   a boundary of the region A and region B is formed in a crystal plane belonging to equivalent crystal planes expressed by {110}, wherein
      (a) the region A is a region, in which the periodic content ratio change of Ti, Al and Me is aligned along with an orientation belonging to equivalent crystal orientations expressed by <001> in a cubic crystal grain, and in a case where the orientation is defined as an orientation d_{A}, a period along the orientation d_{A} is 3 nm to 30 nm and a maximum ΔXod_{A} of a change of content ratio x ofAl in a plane perpendicular to the orientation d_{A} is 0.01 or less, and
      (b) the region B is a region, in which the periodic content ratio change of Ti, Al and Me is aligned along with an orientation, which is perpendicular to the orientation d_{A}, belonging to equivalent crystal orientations expressed by <001> in a cubic crystal grain, and in a case where the orientation is defined as an orientation d_{B}, a period along the orientation d_{B} is 3 nm to 30 nm and a maximum ΔXod_{B} of a change of content ratio x of Al in a plane perpendicular to the orientation d_{B} is 0.01 or less.
(4) The surface coated cutting tool according to any one of the above-described (1) to (3), wherein a lattice constant a of the crystal grains having the NaCl type face-centered cubic structure satisfies a relationship, 0.05a_{TiN}+0.95a_{AlN}≤a≤0.4a_{TiN}+0.6a_{AlN} relative to a lattice constant a_{TiN} of a cubic TiN and a lattice constant a_{AlN} of a cubic AlN, the lattice constant a of the crystal grains having the NaCl type face-centered cubic structure being obtained from X-ray diffraction on the complex nitride or carbonitride layer.
(5) The surface coated cutting tool according to any one of the above-described (1) to (4), wherein
   in a case where the complex nitride or carbonitride layer is observed from the vertical cross sectional direction of the layer, the surface coated cutting tool includes a columnar structure, in which an average grain width W and an average aspect ratio A of the crystal grains of the Ti, Al and Me complex nitride or carbonitride having the NaCl type face-centered cubic structure are 0. 1 µm to 2.0 µm and 2 to 10, respectively.
(6) The surface coated cutting tool according to any one of the above-described (1) to (5), wherein
   an area ratio of the complex nitride or carbonitride having the NaCl type face-centered cubic structure is 70 area% or more in the complex nitride or carbonitride layer.
(7) The surface coated cutting tool according to any one of the above-described (1) to (6), further including a lower layer between the tool body made of any one of tungsten carbide-based cemented carbide, titanium carbonitride-based cermet, and cubic boron nitride-based ultra-high pressure sintered material; and the Ti, Al and Me complex nitride or carbonitride layer, the lower layer includes a Ti compound layer, which is made of one or more layers selected from a group consisting of a Ti carbide layer; a Ti nitride layer; a Ti carbonitride layer; a Ti oxycarbide layer; and a Ti oxycarbonitride layer, and has an average total layer thickness of 0.1 µm to 20 µm.
(8) The surface coated cutting tool according to any one of the above-described (1) to (7), further including an upper layer in an upper part of the complex nitride or carbonitride layer, the upper layer includes at least an aluminum oxide layer with an average layer thickness of 1 µm to 25 µm.
(9) A method of manufacturing the surface coated cutting tool according to any one of the above-described (1) to (8), the complex nitride or carbonitride layer is formed by a chemical vapor deposition method, a reaction gas component of which includes at least trimethyl aluminum.

Having the complex nitride or carbonitride layer is the essential configuration of the hard coating layer (hereinafter, referred as "the hard coating layer of the present invention") of the surface-coated cutting tool, which is an aspect of the present invention. It is needless to say that an even more excellent property can be obtained by having the hard coating layer with the conventionally known, the lower layer described in (7) indicated above, the upper layer described in (8) indicated above, or the like in cooperation with the technical effect of the complex nitride or the complex carbonitride layers.

The present invention is explained in detail below.

### Average layer thickness of the complex nitride or carbonitride layer 2 constituting the hard coating layer:

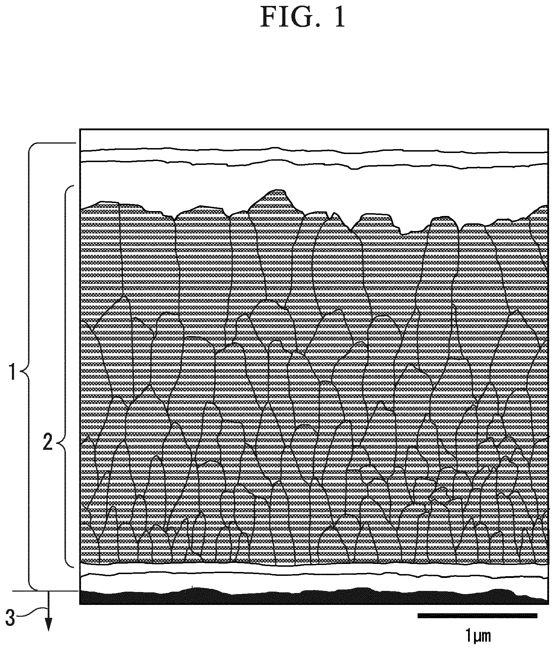

The schematic diagram of the cross section of the Ti, Al and Me complex nitride or carbonitride layer 2 constituting the hard coating layer of the present invention is shown in FIG. 1.

The hard coating layer included in the surface coated cutting tool of the present invention includes at least the Ti, Al and Me complex nitride or carbonitride layer 2 represented by the composition formula (Ti_{1-x-y}AlₓMe_{y})(C_{z}N_{1-z}). The complex nitride or carbonitride layer 2 has a high hardness and an excellent wear resistance. In particular, when the average total layer thickness of the Ti, Al and Me complex nitride or carbonitride layer 2 is 1-20 µm, the advantageous effect is distinctly exerted. The reason for this is that: if the average layer thickness was less than 1 µm, it would be impossible to obtain sufficient wear resistance for a long-term usage since the layer thickness is too thin; and if the average layer thickness exceeded 20 µm, it would be prone to be chipped since the crystal grain size of the Ti, Al and Me complex nitride or carbonitride layer tends to be coarse. Therefore, the average total layer thickness of the complex carbonitride layer is set to 1-20 µm.

Although it is not essential configuration, a more preferable average layer thickness is 3 µm to 15 µm. Ever more preferable average layer thickness is 4 µm to 10 µm.

### Composition of the complex nitride or carbonitride layer 2 constituting the hard coating layer:

In the complex nitride or carbonitride layer 2 constituting the hard coating layer included in the surface coated cutting tool of the present invention, in the case where the composition is expressed by the composition formula: (Ti_{1-x-y}AlₓMe_{y})(C_{z}N_{1-z}), Me being an element selected from Si, Zr, B, V, and Cr, the content ratio X_{avg}, which is the ratio of Al to the total amount of Ti Al, and Me; the content ratio Y_{avg}, which is the ratio of Me to the total amount of Ti Al, and Me; and Z_{avg}, which is the ratio of C to a total amount of C and N, are adjusted to satisfy 0.60≤X_{avg}, 0.005≤Y_{avg}≤0.10, 0≤Z_{avg}≤0.005, and 0.605≤X_{avg}+ Y_{avg} ≤0.95), provided that each of X_{avg}, Y_{avg} and Z_{avg} is in atomic ratio.

The reason for that is that if the average Al content ratio X_{avg} were less than 0.60, hardness of the Ti, Al and Me complex nitride or carbonitride layer 2 would be inferior. Thus, in the case where it is applied to high-speed intermittent cutting of alloy steel or the like, wear resistance is insufficient.

In addition, if the average Me content Y_{avg} were less than 0.005, hardness of the Ti, Al and Me complex nitride or carbonitride layer 2 would be inferior. Thus, in the case where it is applied to high-speed intermittent cutting of alloy steel or the like, wear resistance is insufficient. On the other hand, if it exceeded 0.10, toughness of the Ti, Al and Me complex nitride or carbonitride layer 2 would be reduced due to segregation of Me in grain boundaries or the like. Thus, in the case where it is applied to high-speed intermittent cutting of alloy steel or the like, chipping resistance is insufficient. Therefore, the average Me content Y_{avg} is set in the range of 0.005≤Y_{avg}≤0.10.

On the other hand, if the sum of the average Al content X_{avg} and the average Me content Y_{avg}, X_{avg}+Y_{avg} were less than 0.605, hardness of the Ti, Al and Me complex nitride or carbonitride layer 2 would be inferior. Thus, in the case where it is applied to high-speed intermittent cutting of alloy steel or the like, wear resistance is insufficient. If it exceeded 0.95, the Ti content would be relatively reduced, leading to embrittlement of the layer. Thus, chipping resistance is reduced. Therefore, the sum of the average Al content X_{avg} and the average Me content Y_{avg}, X_{avg}+Y_{avg} is set to the range of 0.605≤X_{avg}+ Y_{avg}≤0.95.

As a specific component of Me, one element selected from Si, Zr, B, V, and Cr is used.

In the case where the Si component or the B component is used in such a way that Y_{avg} is set to 0.005 or more, the hardness of the Ti, Al and Me complex nitride or carbonitride layer 2 is improved. Thus, wear resistance is improved. The Zr component has an effect strengthening the crystal grain boundaries. The V component improves toughness. Thus, by adding Zr and/or V, chipping resistance is improved further more. The Cr component improves oxidation resistance. Thus, further elongating the service life of the tool can be expected. However, in any one of these elements, if the average content ratio Y_{avg} exceeded 0.10, the wear resistance or the chipping resistance would show the tendency of deterioration since the average content ratios of the Al component and the Ti component are relatively reduced. Thus, having an average content ratio Y_{avg} exceeding 0.10 should be avoided.

In addition, when the average C content ratio (in atomic ratio) Z_{avg} included in the complex nitride or carbonitride layer 2 is extremely small amount in the range of 0≤y≤0.005, adhesive strength of the complex nitride or carbonitride layer 2 to the tool body 3 or the lower layer is improved; and lubricity is also improved. Because of these, impact during cutting is alleviated. As a result, fracture resistance and chipping resistance of the complex nitride or carbonitride layer 2 are improved. On the other hand, having the average C content ratio Z_{avg} out of the range of 0≤ Z_{avg} ≤0.005 is unfavorable since toughness of the complex nitride or carbonitride layer 2 is reduced, which leads to adversely reduced fracture resistance and chipping resistance. Because of the reason described above, the average C content ratio Z_{avg} is set to 0≤ Z_{avg} ≤0.005.

Although it is not essential configuration, preferably, X_{avg}, Y_{avg}, and Z_{avg} are set to satisfy: 0.70≤X_{avg}≤0.85; 0.01≤Y_{avg}≤0.05; 0≤Z_{avg}≤0.003; and 0.7≦X_{avg}+Y_{avg}≦0.90.

### Inclined angle frequency distribution of the {111} planes, which are crystal planes of individual crystal grains having a NaCl type face-centered cubic structure in the Ti, Al and Me complex nitride or carbonitride layer 2 (the (Ti_{1-x-y}AlₓMe_{y})(C_{z}N_{1-z}) layer):

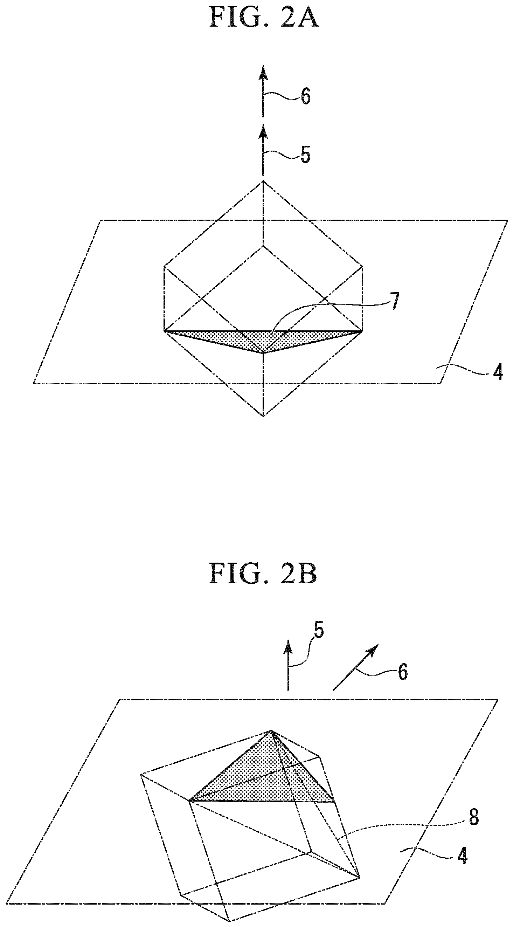

The hard coating layer made of the Ti, Al and Me complex nitride or carbonitride layer 2 has a high hardness while retaining the NaCl type face-centered cubic structure, in the case where, when crystal orientations of individual crystal grains having the NaCl type face-centered cubic structure in the above-described (Ti_{1-x-y}AlₓMe_{y})(C_{z}N_{1-z}) layer of the present invention are analyzed from a vertical cross sectional direction with an electron beam backward scattering diffraction device, inclined angles of normal lines 6 of {111} planes, which are crystal planes of the crystal grains, relative to the direction of the normal line 5 of the surface of the tool body (the direction perpendicular to the surface of the tool body 4 in the polished cross section) are measured (refer FIGS. 2A and 2B), and the inclined angle frequency distribution is obtained by tallying frequencies present in each section after dividing inclined angles into sections in every 0.25° pitch in the range of 0 to 45° relative to the direction of the normal line among the inclined angles, the inclined angle frequency distribution pattern, in which the highest peak is present in the inclined angle section in the range of 0° to 12°, and the ratio of the sum of frequencies in the range of 0° to 12° to the overall frequency in the inclined angle frequency distribution is 35% or more, is observed. Furthermore, by having the above-described inclined angle frequency distribution pattern, adhesive strength between the hard coating layer and the body improves drastically.

Therefore, by using the coated tool configured as explained above, formation of chipping, fracture, peeling, and the like are suppressed, for example, even in the case where it is used in high-speed intermittent cutting of alloy steel or the like; and the coated tool exhibits excellent wear resistance.

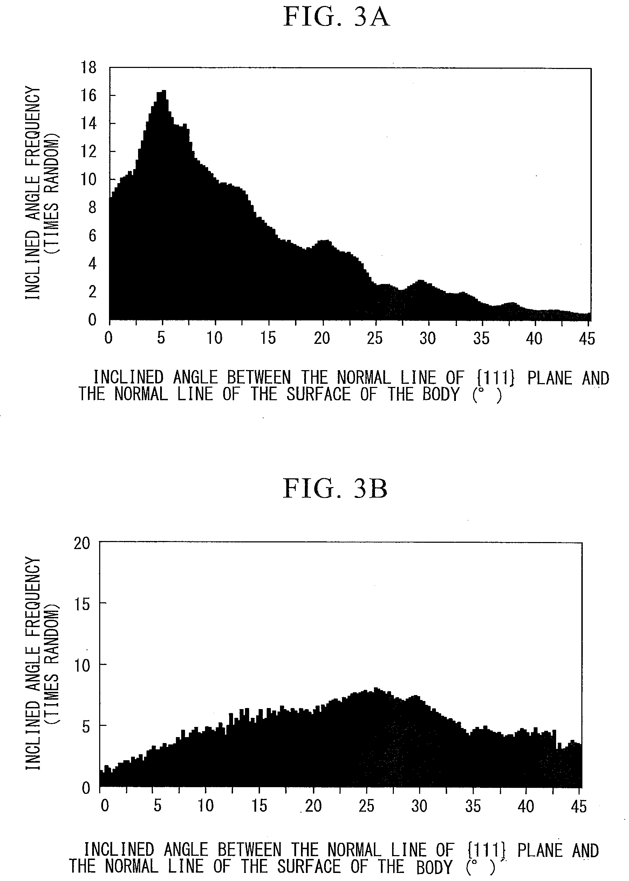

Crystal grains corresponding to an embodiment of the present invention, and ones for comparison, both of which have a cubic structure, are subjected to the above-described measurement method. Examples of the obtained inclined angle frequency distributions are shown as graphs in FIGS. 3A and 3B.

### Crystal grains constituting the complex nitride or carbonitride layer 2 and having the NaCl type face-centered cubic structure (hereinafter, referred as "cubic"):

It is preferable that the average grain width W is adjusted to satisfy being 0.1 µm to 2.0 µm; and the average aspect ratio A is adjusted to satisfy being 2 to 10. The average aspect ratio A is the average value of aspect ratios "a" obtained relative to individual crystal grains. The average grain width W is the average value of grain widths "w" obtained relative to individual crystal grains. The aspect ratio "a" is the ratio of "l" to "w", l/w, of each crystal grain. The grain width "w" is the grain width in the direction parallel to the surface 4 of the tool body with respect to each cubic crystal grain in the complex nitride or carbonitride layer in the case where the cross section is observed and subjected to measurement from the direction perpendicular to the surface 4 of the tool body. Similarly, the grain length is the grain length in the direction perpendicular to the surface of the tool body with respect to each cubic crystal grains in the complex nitride or carbonitride layer.

When this condition is satisfied, the cubic crystal grains constituting the complex nitride or carbonitride layer 2 become the columnar structure and show excellent wear resistance. Contrary to that, it is unfavorable to have the average aspect ratio A less than 2 since it becomes hard to form the periodical composition distribution (concentration change, content ratio change), which is a unique feature of the present invention, in the crystal grains having the NaCl type face-centered cubic structure. In addition, it is unfavorable to have columnar crystals having the average aspect ratio A exceeding 10 since it becomes easy for cracks to grow in such a way to travel along planes along the periodical composition distribution in the cubic crystal phase, which is a unique feature of the present invention, and grain boundaries. In addition, if the average grain width W were less than 0.1 µm, the wear resistance would be reduced. If it exceeded 2.0 µm, the toughness would be reduced. Therefore, it is preferable that the average grain width W of the cubic crystal grains constituting the Ti, Al and Me complex nitride or carbonitride layer 2 is 0.1 µm to 2.0 µm.

Although it is not essential configuration, preferably, the average aspect ratio A; and the average grain width W, are 4 to 7; and 0.7 µm to 1.5 µm, respectively.

### Concentration change of Ti, Al and Me existing in the crystal grains having the cubic crystal structure:

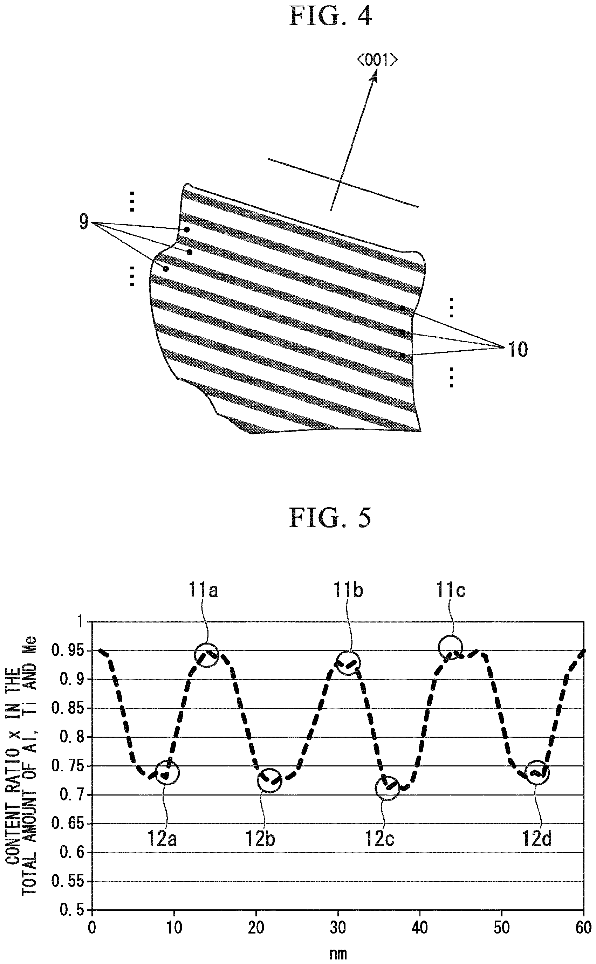

In FIG. 4, a periodic change of concentrations of Ti, Al and Me existing along one orientation among the equivalent crystal orientations expressed by <001> of the cubic crystal grain; and the change of the Al content ratio x in the plane perpendicular to the orientation being small, are shown as a schematic diagram, regarding the crystal grains having the cubic crystal structure in the Ti, Al and Me complex nitride or carbonitride layer (hereinafter, referred as "the Ti, Al and Me complex nitride or carbonitride layer of the present invention") included in the hard coat layer of the present invention.

In FIG. 5, an example of a graph of a periodical concentration change of the content ratio x of Al to the total of the content ratios of Ti, Al and Me is shown. The graph is results of performing a liner analysis by the energy dispersive X-ray spectroscopy (EDS) with a transmission electron microscope on a crystal grain, in which a periodical concentration change of Ti, Al and Me exists, having a cubic crystal structure, on the cross section of the Ti, Al and Me complex nitride or carbonitride layer of the present invention.

In the case where the composition of the crystal having the cubic crystal structure is expressed by the composition formula: (Ti_{1-x-y}AlₓMe_{y})(C_{z}N_{1-z}), when there is a periodical concentration change of Ti, Al and Me in the crystal grain (in other words, each of x, y, and z are not a constant value, but fluctuate periodically), strain is introduced in the crystal grain and hardness is improved. However, if the difference Δx between Xₘₐₓ and Xₘᵢₙ were less than 0.03, the above-described strain in the cubic crystal grain would be lowered, and sufficient improvement of hardness would not be expected. The value x is a major indicator of the concentration change of Ti, Al and Me. Xₘₐₓ is the average value of the local maximums 11a, 11b, 11c,... of the periodically fluctuating values of x, which is the content ratio x of Al in the composition formula. Xₘᵢₙ is the average value of the local minimums 12a, 12b, 12c, 12d,... of the periodically fluctuating values of x, which is the content ratio x of Al in the composition formula. On the other hand, if the difference Δx between Xₘₐₓ and Xₘᵢₙ exceeded 0.25, strain in the crystal grain would become too high, which leads to a larger lattice defect and lowered hardness. Because of the reason described above, in terms of the concentration change of Ti, Al and Me existing in the crystal grain having the cubic crystal structure, the difference between Xₘₐₓ and Xₘᵢₙ is set to 0.03 to 0.25.

Although it is not essential configuration, preferably, the difference between Xₘₐₓ and Xₘᵢₙ is set to 0.05 to 0.22. More preferably, it is set to 0.08 to 0.15.

In addition, in terms of the periodical composition change of Ti and Al, if the period were less than 3 nm, the toughness would be reduced. On the other hand, if it exceeded 100 nm, no effect of the improvement of the hardness would not be expected. Thus, the period is set to 3 nm to 100 nm.

Although it is not essential configuration, a more preferable period of the concentration change is 15 nm to 80 nm. Even more preferably, it is 25 nm to 50 nm.

In addition, in the case where the periodic content ratio change of Ti, Al and Me is aligned along with an orientation belonging to equivalent crystal orientations expressed by <001 > in a cubic crystal grain, it becomes harder for a lattice defect due to strain in the crystal grain; and toughness is improved i regarding the cubic phase crystal grains, in which the periodic content ratio change of Ti, Al and Me exists in the complex nitride or carbonitride layer, having a cubic crystal structure.

In addition, the content ratios of Ti, Al and Me are not changed substantially in the plane perpendicular to the orientation in which the above-described periodic content ratio change of Ti, Al and Me exists. In addition, the maximum ΔXo of the change amount of the content ratio x of Al to the total of Ti, Al and Me is 0.01 or less in the above-described perpendicular plane.

In addition, when the period of the content ratio change along with an orientation belonging to equivalent crystal orientations expressed by <001> in the cubic crystal grain is less than 3 nm, toughness is reduced. When it exceeds 100 nm, the effect of the hardness improvement cannot be exhibited sufficiently. Because of the reason described above, it is preferable that the period of the content ratio change is set to 3 nm to 100 nm.

Although it is not essential configuration, preferably, the period of the content ratio change is set to 25 nm to 50 nm.

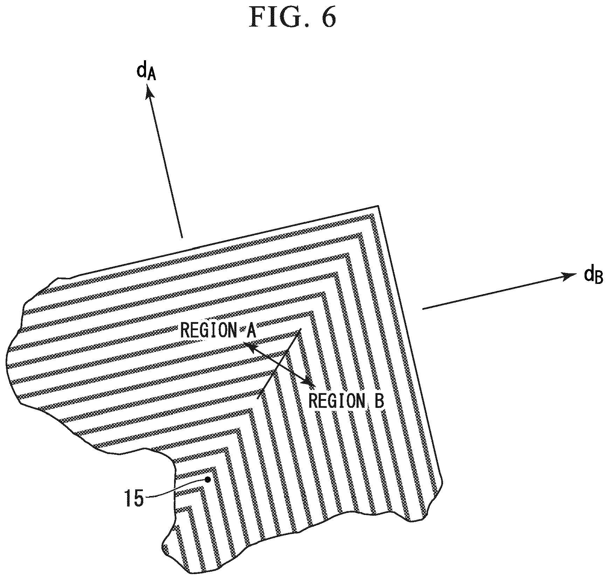

In FIG. 6, the region A (13) and the region B (14) existing in the crystal grain is shown as a schematic diagram, regarding the crystal grain, in which the periodical concentration change of Ti, Al and Me exists, having a cubic crystal structure on the cross section of the Ti, Al and Me complex nitride or carbonitride layer of the present invention.

In terms of the crystal grain in which two periodic content ratio changes of Ti, Al and Me in two directions at right angles to each other exist in the crystal grain as the region A (13) and the region B (14) (14), toughness is improved further because of the existence of strain in two directions in the crystal grain. Moreover, high toughness can be maintained since misfit in the boundary 15 between the region A (13) and the region B (14) does not occur because the boundary between the region A (13) and the region B (14) is formed in a crystal plane belonging to equivalent crystal planes expressed by {110}.

In other words, the toughness is improved by having the stain in two directions in the crystal grains; and the high toughness can be retained since the misfit in the boundary 15 between the region A (13) and the region B (14) does not occur because the boundary 15 between the region A (13) and the region B (14) is formed in a crystal plane belonging to equivalent crystal planes expressed by {110}, when the region A (13), in which the periodic content ratio change of Ti, Al and Me is aligned along with an orientation belonging to equivalent crystal orientations expressed by <001> in a cubic crystal grain, and in a case where the orientation is defined as the orientation d_{A}, the period along the orientation d_{A} is 3 nm to 30 nm and the maximum ΔXod_{A} of the change of content ratio x of Al in the plane perpendicular to the orientation d_{A} is 0.01 or less; and the region B (14), in which the periodic content ratio change of Ti, Al and Me is aligned along with an orientation, which is perpendicular to the orientation d_{A}, belonging to equivalent crystal orientations expressed by <001> in a cubic crystal grain, and in a case where the orientation is defined as an orientation d_{B}, a period along the orientation d_{B} is 3 nm to 30 nm and a maximum ΔXod_{B} of a change of content ratio x of Al in a plane perpendicular to the orientation d_{B} is 0.01 or less, are formed.

### The lattice constant "a" of the cubic crystal grain in the complex nitride or carbonitride layer:

Regarding the complex nitride or carbonitride layer 2, X-ray diffraction experiment is performed using a X-ray diffraction apparatus using Cu-Kα ray as the radiation source to obtain the lattice constant "a" of the above-described cubic crystal grain. When the lattice constant "a" of the cubic crystal grain satisfies the relationship, 0.05a_{TiN}+0.95a_{AlN}≤a≤0.4a_{TiN}+0.6a_{AlN} relative to the lattice constant a_{TiN} of the cubic TiN (JCPDS00-038-1420), which is 4.24173Å, and the lattice constant a_{AlN} of the cubic AlN (JCPDS00-046-1200), which is 4.045Å, the crystal grain shows an even higher hardness and a high thermal conductivity. As a result, the complex nitride or carbonitride layer obtains excellent wear resistance and excellent thermal shock resistance. X-ray diffraction is performed by using an X-ray diffraction apparatus in the condition of: 13°≤2θ≤130° of the measurement range; 0.02° of the measurement width; and 0.5 second/step of the measurement time. The peak and crystal plane attributed to the Ti, Al and Me complex nitride or carbonitride layer having the cubic structure are identified from the obtained diffraction peaks. On each peak, the interplanar spacing of the crystal planes is calculated from the wavelength of the used Cu-Kα ray and the angle of the peak. The lattice constant a is the average value of the calculated lattice constants calculated from the values of the interplanar values.

### Area ratio of the columnar structure made of the individual crystal grains having the cubic structure in the complex nitride or carbonitride layer 2:

It is not preferable that the area ratio of the columnar structure made of the individual crystal grains having the cubic structure is less than 70 area%, since the hardness is relatively reduced.

Although it is not essential configuration, preferably, the area ratio of the columnar structure made of the individual crystal grains having the cubic structure is 85 area% or more. More preferably, it is 95 area% or more.

Also, when the complex nitride or carbonitride layer 2 of the present invention includes the Ti compound layer as the lower layer; the Ti compound layer is made of one layer or more than two layers selected from the group consisting of Ti carbide layer, Ti nitride layer, Ti carbonitride layer, Ti oxycarbide layer, and Ti oxycarbonitride layer; and the average total thickness of the Ti compound layer is 0.1 to 20 µm, and/or when the complex carbonitride layer includes aluminum oxide layer with the average thickness of 1-25 µm as the upper layer, the above-mentioned properties are not deteriorated. Rather, by combining the complex nitride or carbonitride layer with these conventionally known lower layer and upper layer, even more superior property can be created in cooperation with the technical effect of these layers. In the case where the Ti compound layer, which is made of one or more layers of a Ti carbide layer, a Ti nitride layer, a Ti carbonitride layer, a Ti oxycarbide layer, and a Ti oxycarbonitride layer , is included as the lower layer, when the average total layer thickness of the Ti compound layer exceeds 20 µm, the crystal grain is prone to be coarse, and chipping is prone to occur. In addition, in the case where an aluminum oxide layer is included as the upper layer, when the average total thickness of the aluminum oxide layer exceeds 25 µm, the crystal grain is prone to be coarse, and chipping is prone to occur. On the other hand, when the thickness of the lower layer is less than 0.1 µm, the improvement effect of the adhesive strength between the complex nitride or carbonitride layer 2 of the present invention and the lower layer cannot be expected. In addition, when the thickness of the upper layer is less than 1 µm, the improvement effect of the wear resistance by depositing the upper layer becomes unnoticeable.

### [Effects of the Invention]

The surface coated cutting tool of the present invention includes: a tool body made of any one of tungsten carbide-based cemented carbide, titanium carbonitride-based cermet, and cubic boron nitride-based ultra-high pressure sintered material; and a hard coating layer formed on a surface of the tool body. The hard coating layer includes at least a Ti, Al and Me complex nitride or carbonitride layer 2 having an average layer thickness of 1 µm to 20 µm. In a case where a composition of the complex nitride or carbonitride layer 2 is expressed by a composition formula: (Ti_{1-x-y}AlₓMe_{y})(C_{z}N_{1-z}), an average content ratio X_{avg}, which is a ratio of Al to a total amount of Ti, Al and Me in the complex nitride or carbonitride layer 2; an average content ratio Y_{avg}, which is a ratio of Me to the total amount of Ti, Al and Me in the complex nitride or carbonitride layer 2; and an average content ratio Z_{avg}, which is a ratio of C to a total amount of C and N, satisfy 0.60≤X_{avg}, 0.005≤Y_{avg}≤0.10, 0≤Z_{avg}≤0.005, and 0.605≤X_{avg}+ Y_{avg} ≤0.95, provided that each of X_{avg}, Y_{avg} and Z_{avg} is in atomic ratio. The complex nitride or carbonitride layer 2 includes at least a phase of complex nitride or carbonitride having a NaCl type face-centered cubic structure (cubic crystal phase). When crystal orientations of crystal grains of a Ti, Al and Me complex nitride or carbonitride having the cubic structure are analyzed from a vertical cross sectional direction with an electron beam backward scattering diffraction device, inclined angles of normal lines 6 of {111} planes, which are crystal planes of the crystal grains, relative to an direction of a normal line of the surface of the tool body are measured, and an inclined angle frequency distribution is obtained by tallying frequencies present in each section after dividing inclined angles into sections in every 0.25° pitch in a range of 0 to 45° relative to the direction of the normal line among the inclined angles, a highest peak is present in an inclined angle section in a range of 0° to 12°, a ratio of a sum of frequencies in the range of 0° to 12° to an overall frequency in the inclined angle frequency distribution is 35% or more. A periodic content ratio change of Ti, Al and Me in the composition formula: (Ti_{1-x-y}AlₓMe_{y})(C_{z}N_{1-z}) exists in the crystal grains having the cubic crystal structure. A difference Δx between Xₘₐₓ and Xₘᵢₙ is 0.03 to 0.25, Xₘₐₓ and Xₘᵢₙ being an average value of local maximums of the periodically fluctuating Al content x and an average value of local minimums of the periodically fluctuating Al content x, respectively. A period along the direction of the normal line of the surface of the tool body is 3 nm to 100 nm in the crystal grains, in which the periodic content ratio change of Ti, Al and Me exists, having the NaCl type face-centered cubic structure. By having the above-described configurations, strain is introduced in the crystal grains having the cubic crystal structure in the complex nitride or carbonitride layer 2. Because of this, hardness of the crystal grain is improved; and toughness is also improved, while keeping the high wear resistance.

As a result, the chipping resistant improvement effect is exhibited; the coated tool exhibits excellent cutting performance for a long-term usage compared to the conventional hard coating layer; and the longer service life of the coated tool is achieved.

### BRIEF DESCRIPTION OF THE DRAWINGS

FIG. 1 is a schematic diagram of the layer constitution showing the cross section of the Ti, Al and Me complex nitride or carbonitride layer 2 constituting the hard coating layer 1 in the present invention schematically. A horizontal striped pattern is the periodic change of the Al content ratio in crystal grains constituting the Ti, Al and Me complex nitride or carbonitride layer.
FIG. 2A is a schematic diagram showing the case (7), in which the inclined angle 6 of the normal line of the {111} plane, which is a crystal plane of the crystal grain, relative to the normal line 5 of the surface of the tool body (direction perpendicular to the surface 4 of the tool body (the polished face of the surface of the tool body) on the polished cross section) is 0°.
FIG. 2B is a schematic diagram showing the case (8), in which the inclined angle 6 of the normal line of the {111} plane, which is a crystal plane of the crystal grain, relative to the normal line 5 of the surface of the tool body (direction perpendicular to the surface 4 of the tool body (polished face of the surface of the tool body) on the polished cross section) is 45°.
FIG. 3A is a graph showing an example of the inclined angle frequency distribution obtained on crystal grains having a cubic structure on the cross section of the Ti, Al and Me complex nitride or carbonitride layer 2 constituting the hard coating layer 1 of the present invention.
FIG. 3B is a graph showing an example of the inclined angle frequency distribution obtained on crystal grains having a cubic structure on the cross section of the Ti, Al and Me complex nitride or carbonitride layer constituting the hard coating layer 1 of a comparative example.
FIG. 4 is a schematic diagram schematically showing: the periodic content ratio change of Ti, Al and Me is aligned along with an orientation (indicated by an arrow) belonging to equivalent crystal orientations expressed by <001> in a cubic crystal grain; and the change of the content ratio x of Al in the plane perpendicular to the orientation (the plane seen from the side is indicated by the line perpendicular to the arrow) is minimum, in regard to the crystal grains, in which the periodic content ratio change of Ti, Al and Me exists, having a cubic crystal structure in the cross section of the Ti, Al and Me complex nitride or carbonitride layer 2 constituting the hard coating layer 1 corresponding to the first embodiment of the present invention. Specifically, the change of the content ratio x of Al in the perpendicular plane is 0.01 or less. The bright parts indicate the regions 9, in which the Al content is relatively high. The dark parts indicate the region 10, in which the Al content is relatively low.
FIG. 5 shows an example of a graph of a periodical concentration change of the content ratio x of Al to the total of the content ratios of Ti, Al and Me. The graph is results of performing a liner analysis by the energy dispersive X-ray spectroscopy (EDS) with a transmission electron microscope on a crystal grain, in which a periodical concentration change of Ti, Al and Me exists, having a cubic crystal structure, on the cross section of the Ti, Al and Me complex nitride or carbonitride layer constituting the hard coating layer 1 corresponding an embodiment of the present invention. Specifically, the periodical concentration change of Al in the crystal grain having the cubic structure in the complex nitride or carbonitride layer 2 is shown. In the graphs, three local maximums 11a, 11b, and11c; and four local minimums 12a, 12b, 12c, and 12d are shown.
FIG. 6 is a schematic diagram showing that the region A (13) and region B (14) exist in the crystal grain, in regard to crystal grains, in which the periodic content ratio change of Ti, Al and Me exists, having a cubic crystal structure in the cross section of the Ti, Al and Me complex nitride or carbonitride layer 2 constituting the hard coating layer 1 corresponding to the first embodiment of the present invention. The boundary 15 is formed in the part where the region A (13) and the region B (14) contact each other.

### EMBODIMENTS OF THE INVENTION

The surface coated cutting tool of the present invention includes: a cemented carbide tool body, which is made of any one of tungsten carbide-based cemented carbide, titanium carbonitride-based cermet, and cubic boron nitride-based ultra-high pressure sintered material; and a hard coating layer 1 formed on a surface of the tool body 3. The hard coating layer 1 includes at least a Ti, Al and Me complex nitride or carbonitride layer 2, which has an average layer thickness of 1 µm to 20 µm. In a case where a composition of the complex nitride or carbonitride layer 2 is expressed by a composition formula: (Ti_{1-x-y}AlₓMe_{y})(C_{z}N_{1-z}), an average content ratio X_{avg}, which is a ratio of Al to a total amount of Ti, Al and Me; an average content ratio Y_{avg}, which is a ratio of Me to the total amount of Ti, Al and Me; and an average content ratio Z_{avg}, which is a ratio of C to a total amount of C and N, satisfy 0.60≤X_{avg}, 0.005≤Y_{avg}≤0.10, 0≤Z_{avg}≤0.005, and 0.605≤X_{avg}+ Y_{avg} ≤0.95, provided that each of X_{avg}, Y_{avg} and Z_{avg} is in atomic ratio. The crystal grains constituting the complex nitride or carbonitride layer 2 include at least crystal grains having a cubic crystal structure. When crystal orientations of crystal grains having the cubic structure are analyzed from a vertical cross sectional direction with an electron beam backward scattering diffraction device, inclined angles of normal lines 6 of {111} planes, which are crystal planes of the crystal grains, relative to an direction of a normal line of the surface of the tool body are measured, and an inclined angle frequency distribution is obtained by tallying frequencies present in each section after dividing inclined angles into sections in every 0.25° pitch in a range of 0 to 45° relative to the direction of the normal line among the inclined angles, a highest peak is present in an inclined angle section in a range of 0° to 12°, a ratio of a sum of frequencies in the range of 0° to 12° to an overall frequency in the inclined angle frequency distribution is 35% or more. A periodic content ratio change of Ti, Al and Me in the composition formula: (Ti_{1-x-y}AlₓMe_{y})(C_{z}N_{1-z} exists in the crystal grains having the cubic crystal structure. A difference Δx between Xₘₐₓ and Xₘᵢₙ is 0.03 to 0.25, Xₘₐₓ and Xₘᵢₙ being an average value of local maximums of the periodically fluctuating Al content x and an average value of local minimums of the periodically fluctuating Al content x, respectively. A period along the direction of the normal line of the surface of the tool body is 3 nm to 100 nm in the crystal grains, in which the periodic content ratio change of Ti, Al and Me exists, having the NaCl type face-centered cubic structure. By having the above-described configurations, the chipping resistance is improved; the coated tool exhibits excellent cutting performance for a long-term usage compared to the conventional hard coating layer; and the longer service life of the coated tool is achieved. As long as the above-described criterions are satisfied, any form of embodiment can be chosen.

Next, the coated tool of the present invention is explained specifically by using Examples.

### [Example 1]

As raw material powders, the WC powder, the TiC powder, the TaC powder, the NbC powder, the Cr₃C₂ powder, and the Co powder, all of which had the average grain sizes of 1-3 µm, were prepared. These raw material powders were blended in the blending composition shown in Table 1. Then, wax was added to the blended mixture, and further mixed in acetone for 24 hours with a ball mill. After drying under reduced pressure, the mixtures were press-molded into green compacts with a predetermined shape under pressure of 98 MPa. Then, the obtained green compacts were sintered in vacuum in the condition of 5 Pa vacuum at the predetermined temperature in the range of 1370-1470°C for 1 hour retention. After sintering, the tool bodies A-C, which had the insert-shape defined by ISO-SEEN1203AFSN and made of WC-based cemented carbide, were produced.

Also, as raw material powders, the TiCN powder (TiC/TiN=50/50 in mass ratio), the Mo₂C powder, the ZrC powder, the NbC powder, the WC powder, the Co powder, and the Ni powders, all of which had the average grain sizes of 0.5-2 µm, were prepared. These raw material powders were blended in the blending composition shown in Table 2. Then, with a ball mill, the obtained mixtures were subjected to wet-mixing for 24 hours. After drying, the mixtures were press-molded into green compacts under pressure of 98 MPa. The obtained green compacts were sintered in the condition of: in nitrogen atmosphere of 1.3 kPa; at a temperature of 1500°C; and for 1 hour of the retention time. After sintering, the tool body D, which had the insert-shape defined by ISO-SEEN1203AFSN and made ofTiCN-based cermet, was produced.

Next, the coated tools of the present invention 1-15 were produced by performing the thermal CVD method for predetermined times to form the hard coating layer made of the (Ti_{1-x-y}AlₓMe_{y})(C_{z}N_{1-z}) layer having the intended layer thicknesses shown in Table 7 on the surfaces of the tool bodies A to D by using a chemical vapor deposition apparatus. The formation condition is as shown in Table 4. The gas group A was made of NH₃ and N₂. The gas group B was made of TiCl₄, Al(CH₃)₃, AlCl₃, MeClₙ (any one of SiCl₄, ZrCl₄, BCl₃, VCl₄, and CrCl₂), NH₃, N₂, and H₂. Suppling method of each of gases was as follows. The composition of the reaction (volume% to the total amount including the gas group A and the gas group B) gas included: 1.0% to 1.5% of NH₃, 0% to 5% of N₂ and 55% to 60% of H₂ as the components from the gas group A; and 0.6% to 0.9% of AlCl₃, 0.2% to 0.3% of TiCl₄, 0% to 0.5% of Al(CH₃)₃, 0.1% to 0.2% of MeClₙ (any one of SiCl₄, ZrCl₄, BCl₃, VCl₄, and CrCl₂), 0.0% to 12.0% of N₂, and the H₂ balance as the components from the gas group B. The pressure of the reaction atmosphere was 4.5 to 5.0 kPa. The temperature of the reaction atmosphere was 700 to 900°C. The supplying period was 1 to 5 seconds. The gas supplying time per one period was 0.15 to 0.25 second. The phase difference in supplying the gas groups A and B was 0.10 to 0.20 seconds.

In regard to the coated tools of the present invention 6-13, the lower layer and/or the upper layer were formed as shown in Table 6 in the formation condition shown in Table 3.

In addition, for a comparison purpose, the hard coating layers including a Ti, Al and Me complex nitride or carbonitride layer were deposited on the surfaces of the tool bodies A-D, in the conditions shown in Tables 5, in the intended total layer thicknesses (µm) shown in Table 8. At this time, the comparative coated tools 1-15 were produced by forming the hard coating layer in the coating process of the (Ti_{1-x-y}AlₓMe_{y})(C_{z}N_{1-z}) layer in such a way that the composition of the reaction gas on the surfaces of the tool bodies did not change by time.

As in the coated tools 6-13 of the present invention, in regard to the comparative coated tools 6-13, the lower layer and the upper layer shown in Table 6 were formed in the formation condition shown in Table 3.

On the Ti, Al and Me complex nitride or carbonitride layer constituting the hard coating layers of the coated tools of the present invention 1-15 and the comparative coated tools 1-15, the existence of the peak of the frequencies existing in the range of 0° to 12° was confirmed; and the ratio of the frequencies existing in the range of 0° to 12° was obtained, as explained above. First, the cross section of the hard coating layer in the direction perpendicular to the surface of the tool body, which was in the polished state, was set in the lens barrel of the field emission scanning electron microscope. Then, electron beam with an acceleration voltage of 15 kV was irradiated with an irradiation current of 1 nA on each of crystal grains having the cubic crystal lattice existing in the measurement range on the polished cross section at an incident angle of 70 degrees. Then, on the hard coating layers in the measurement range defined by distances of the layer thickness or less, the inclined angles of the normal line of the {111} plane, which was a crystal plane of the crystal grain, relative to the normal line of the surface of the body (direction perpendicular to the surface of the body on the polished cross section) in every interval of 0.01 µm/step along the cross section in the direction perpendicular to the surface of the tool body in the length of 100 µm in the horizontal direction to the surface of the tool body by using the electron beam backward scattering diffraction device. Based on these measurements, and by dividing the inclined angles in the range of 0 ° to 45° among the obtained inclined angles in every 0.25° pitch and tallying the frequencies existing in each section, the existence of the peak of the frequencies existing in the range of 0 ° to 12° was confirmed; and the ratio of the frequencies existing in the range of 0 ° to 12° was obtained.

In addition, the Ti, Al and Me complex nitride or carbonitride layers constituting the hard coating layers of the coated tools of the present invention 1-15 and the comparative coated tools 1-15 were observed in multiple viewing fields by using the scanning electron microscope (magnification: 5,000 times, and 20,000 times).

In the coated tools of the present invention 1-15, existence of the (Ti_{1-x-y}AlₓMe_{y})(C_{z}N_{1-z}) layer in the columnar structure of the cubic crystals or the columnar structure including the mixed phase of the cubic crystals and the hexagonal crystals was confirmed as shown in the schematic diagram shown in FIG. 1. In addition, existence of the periodical distribution of Ti, Al and Me (the concentration change, the content ratio change) in the cubic crystal grains was confirmed by the surface analysis by energy dispersive X-ray spectroscopy method (EDS) using the transmission scanning electron microscope.

In addition, on the coated tools of the present invention 1-15 and the comparative coated tools 1-15, by using the results of the surface analysis by EDS using the transmission scanning electron microscope, the Xₘₐₓ, which was the average value of the local maximums of x in the five periods of x, and Xₘᵢₙ, which was the average value of the local minimums of x in the five periods of x, were obtained. Then, the difference Δx of them (=Xₘₐₓ-Xₘᵢₙ) was obtained.

It was confirmed that the period was 3 nm to 100 nm; and the value of Δx, which was the difference of the average value of the local maximums and the average value of the local minimums, was in the range of 0.03 to 0.25 in the coated tools of the present invention 1-15.

The cross sections perpendicular to the tool body of each constituent layer of: the coated tools of the present invention 1-15; and the comparative coated tools 1-15, were measured by using a scanning electron microscope (magnification: 5,000). The average layer thicknesses were obtained by averaging layer thicknesses measured at 5 points within the observation viewing field. In any measurement, the obtained layer thickness was practically the same as the intended layer thicknesses shown in Tables7 and 8.

In addition, in regard to the average Al content ratio of the complex nitride layer or the complex carbonitride layer and the average Me content ratio of the coated tools of the present invention 1-15; and the comparative coated tools 1-15, an electron beam was irradiated to the polished surface of the samples from the surface side of the sample by using EPMA (Electron-Probe-Micro-Analyzer). Then, the average Al content ratio X_{avg} and the average Me ratio Y_{avg}, were obtained from 10-point average of the analysis results of the characteristic X-ray. The average C content ratio Z_{avg}, was obtained by secondary-ion-mass-spectroscopy (SIMS).

An ion beam was irradiated on the range of 70 µm × 70 µm from the front surface side of the sample. In regard to the components released by sputtering effect, content ratio measurement in the depth direction was performed. The average C content ratio Z_{avg}, indicates the average value in the depth direction of the Ti, Al and Me complex nitride or carbonitride layer. In terms of the C content ratio, the inevitably included C content ratio, which was included without the intentional use of the gas containing C as the raw material gas, was excluded. Specifically, the content ratio (atomic ratio) of the C component included in the complex nitride or carbonitride layer in the case where the supply amount of Al(CH₃)₃ was set to 0 was obtained as the inevitably included C content ratio. Then, the value, in which the inevitably included C content ratio was subtracted from the content ratio of the C component (atomic ratio) included in the complex nitride or carbonitride layer in the case where Al(CH₃)₃ was intentionally supplied, was obtained as Z_{avg}.

On the coated tools of the present invention 1-15; and the comparative coated tools 1-15, the average aspect ratio A and the average grain width W were obtained as explained below. In regard to the individual crystal grains in the (Ti_{1-x-y}AlₓMe_{y})(C_{z}N_{1-z}) layer constituting the complex nitride or carbonitride layer existing in the length range of 10 µm in the direction horizontal to the surface of the tool body, the grain width "w" in the direction parallel to the surface of the tool body; and the grain length "l" in the direction perpendicular to the surface of the tool body were measured by using a scanning electron microscope (magnification: 5,000 times, 20,000 times) from the cross sectional direction perpendicular to the tool body. Then, the aspect ratio "a" (=l/w) of each of the individual crystal grains were calculated; and the average aspect ratio A was obtained as the average value of the aspect ratios "a." The average grain width W was obtained as the average value of the grain widths "w" obtained from each of the crystal grains.

In the state where the cross section of the hard coating layer in the direction perpendicular to the surface of the tool body, which was made of the Ti, Al and Me complex nitride or carbonitride layer, was polished to be a polished surface,: by setting the sample in the lens barrel of the electron backscatter diffraction apparatus; by irradiating an electron beam to each crystal grain existing within the measurement range in the above-described polished surface of the cross section in the condition where the angle of incidence was 70°, the accelerating voltage was 15kV, and the irradiation current was 1 nA; by measuring the electron backscatter diffraction pattern in the length of 100 µm in the direction horizontal to the surface of the tool body at the interval of 0.01 µm/step in the hard coating layer; and by identifying whether each of crystals was in the cubic crystal structure or in the hexagonal crystal structure by analyzing the crystal structure of each crystal grain, by using an electron backscatter diffraction apparatus.

In addition, observation of the micro region of the complex nitride or carbonitride layer 2 was performed by using a transmission electron microscope; and the plane analysis from the cross section side was performed by using the energy dispersive X-ray spectroscopy (EDS) method. By these observation and analysis, existence of the periodic content ratio change of Ti, Al and Me in the composition formula (Ti_{1-x-y}AlₓMe_{y})(C_{z}N_{1-z}) in the crystal grains having the cubic crystal structure was confirmed. In the case where there was this concentration change existed, the difference Δx (=Xₘₐₓ-Xₘᵢₙ) was obtained: by confirming that the periodic concentration change of Ti, Al and Me existed in an orientation among equivalent crystal orientations expressed by <001> in the cubic crystal grain by performing the electron beam diffraction on the crystal grains; performing the liner analysis in the section corresponding to the five periods along the orientation by EDS; obtaining the average value Xₘₐₓ of the local maximums of the periodical concentration change of Al relative to the total of Ti, Al and Me; and obtaining the average value Xₘᵢₙ of the local minimums of the periodical concentration change of Al relative to the total of Ti, Al and Me in the same section.

In addition, the linear analysis was performed along the direction perpendicular to the orientation among the equivalent crystal orientations expressed by <001> of the cubic crystal grain having the periodical concentration change of Ti, Al and Me in the length corresponding to the section of the above-described five periods. Then, the difference between the maximum and the minimum of the content ratio x of Al in the section was obtained as the maximum ΔXo of the change of the content ratio in the plane perpendicular to the direction perpendicular to the orientation among the equivalent crystal orientations expressed by <001> of the cubic crystal grain having the periodical concentration change of Ti, Al and Me.

In addition, on the crystal grains in which the region A and the region B existed in the crystal grains, the difference Δx (=Xₘₐₓ-Xₘᵢₙ) between the average value Xₘₐₓ of the local maximums of the periodical concentration change of Al relative to the total of Ti, Al and Me in the five periods and the average value Xₘᵢₙ of the local minimums was obtained; and the difference between the maximum and minimum of the content ratio x of Al relative to the total of Ti, Al and Me in the plane perpendicular to the orientation among the equivalent crystal orientations expressed by <001> in the cubic crystal grain having the periodical concentration change of Ti, Al and Me was obtained as the maximum of the content ratio change, to each of the region A and the region B as described above.

That is, in the case where the periodical concentration change of Ti, Al and Me existed along one orientation among equivalent crystal orientations expressed by <001> in the cubic crystal grain in the region A and the orientation was defined as the orientation d_{A}, the difference of the maximum and the minimum of the content ratio x of Al in the section was obtained as the maximum ΔXod_{A} of the change of the content ratio in the plane perpendicular to the direction perpendicular to the orientation among the equivalent crystal orientations expressed by <001> of the cubic crystal grain having the periodical concentration change of Ti, Al and Me by obtaining the period of the concentration change along the orientation d_{A} and performing the linear analysis along the direction perpendicular to the orientation d_{A} in the section having the length corresponding to five periods.

In the case where the periodical concentration change of Ti, Al and Me existed along one orientation among equivalent crystal orientations expressed by <001> in the cubic crystal grain in the region B and the orientation was defined as the orientation d_{B}, the difference of the maximum and the minimum of the content ratio x of Al in the section was obtained as the maximum ΔXod_{B} of the change of the content ratio in the plane perpendicular to the direction perpendicular to the orientation among the equivalent crystal orientations expressed by <001> of the cubic crystal grain having the periodical concentration change of Ti, Al and Me by obtaining the period of the concentration change along the orientation d_{B} and performing the linear analysis along the direction perpendicular to the orientation d_{B} in the section having the length corresponding to five periods.

In addition, on the coated tools of the present invention 1-15, it was confirmed that the boundary between the region A and the region B was formed in one plane among equivalent crystal planes expressed by {110}.

Such confirmations of the period were performed in at least one crystal grain in the viewing field of the micro region of the complex nitride or carbonitride layer using the transmission scanning electron microscope. In addition, in terms of the crystal grains in which the region A and the region B coexisted, the average value was calculated from the values evaluated in at least one crystal grain in the viewing field of the micro region of the complex nitride or carbonitride layer using the transmission scanning electron microscope in each of the region A and the region B in the specific crystal grain.

Each of measurement results described above are shown in Tables 7 and 8.

**[Table 1]**

| Type | | Blending composition (mass%) | | | | | |
|---|---|---|---|---|---|---|---|
| | | Co | TiC | TaC | NbC | Cr₃C₂ | WC |
| Tool body | A | 8.0 | 1.5 | - | 3.0 | 0.4 | balance |
| | B | 8.5 | - | 1.8 | 0.2 | - | balance |
| | C | 7.0 | - | - | - | - | balance |

**[Table 2]**

| Type | | Blending composition (mass%) | | | | | | |
|---|---|---|---|---|---|---|---|---|
| | | Co | Ni | ZrC | NbC | Mo₂C | WC | TiCN |
| Tool body | D | 8 | 5 | 1 | 6 | 6 | 10 | balance |

**[Table 3]**

| Layers constituting the hard coating layer | | | Formation condition (reaction pressure and temperature are indicated by kPa and °C, respectively) | | |
|---|---|---|---|---|---|
| Type | | Formation symbol | Reaction gas composition (volume%) | Reaction atmosphere | |
| | | | | Pressure | Temperature |
| (Ti_{1-x-y}AlₓMe_{y})(C_{z}N_{1-z}) layer | | | Refer Tables 4 and 5 | | |
| Ti compound layer | TiC | TiC | TiCl₄: 2%, CH₄: 10%, H₂: balance | 7 | 850 |
| | TiN | TiN | TiCl₄: 4.2%, N₂: 30%, H₂: balance | 30 | 780 |
| | TiCN | TiCN | TiCl₄: 2%, CH₃CN: 0.7%, N₂:10%, H₂: balance | 7 | 780 |
| | TiCO | TiCO | TiCl₄: 4.2%, CO: 4%, H₂: balance | 7 | 850 |
| | TiCNO | TiCNO | TiCl₄: 2%, CH₃CN: 0.7%, N₂: 10%, CO₂: 0.3%, H₂: balance | 13 | 780 |
| Al₂O₃ compound layer | Al₂O₃ | Al₂O₃ | AlCl₃: 2.2%, CO₂: 5.5%, HCl: 2.2%, H₂S: 0.8%, H₂: balance | 7 | 800 |

**[Table 4]**

| Formation of the hard coating layer | | Formation condition (the composition of the reaction gas indicates the ratio relative to the sum of the gas group A and the gas group B. Units of pressure and temperature of the reaction atmosphere are kPa and °C, respectively) | | | | | | | | |
|---|---|---|---|---|---|---|---|---|---|---|
| Process type | Formation symbol | Composition of the reaction gas group A (volume%) | Gas group A | | Composition of the reaction gas group B (volume%) | Gas group B | | Phase difference of supplying the gas groups A and B (second) | Reaction atmosphere | |
| | | | Supply period (second) | Supply time per a period (second) | | Supply period (second) | Supply time per a period (second) | | Pressure | Temperature |
| | Si-A | NH₃: 1.2 %, N₂: 0 %, H₂: 58 %, | 2 | 0.15 | AlCl₃: 0.7 %, TiCl₄: 0.2 %, SiCl₄: 0.1 %, N₂: 5%, Al(CH₃)₃: 0%, balance H₂ | 2 | 0.15 | 0.10 | 4.5 | 750 |
| | Si-B | NH₃: 1.5 %, N₂: 2 %, H₂: 57 %, | 4 | 0.25 | AlCl₃: 0.8 %, TiCl₄: 0.3 %, SiCl₄: 0.2 %, N₂: 2%, Al(CH₃)₃: 0%, balance H₂ | 4 | 0.25 | 0.20 | 5.0 | 850 |
| | Si-C | NH₃: 1.1 %, N₂: 1 %, H₂: 60 %, | 3 | 0.20 | AlCl₃: 0.6 %, TiCl₄: 0.3 %, SiCl₄: 0.1 %, N₂: 7%, Al(CH₃)₃: 0.2%, balance H₂ | 3 | 0.20 | 0.15 | 4.5 | 800 |
| | Zr-A | NH₃: 1.4 %, N₂: 3 %, H₂: 56 %, | 4 | 0.20 | AlCl₃: 0.9 %, TiCl₄: 0.2 %, ZrCl₄: 0.1 %, N₂: 4%, Al(CH₃)₃: 0.5%, balance H₂ | 4 | 0.20 | 0.15 | 5.0 | 700 |
| Deposition process in the present invention | Zr-B | NH₃: 1.0 %, N₂: 0 %, H₂: 55 %, | 5 | 0.25 | AlCl₃: 0.8 %, TiCl₄: 0.3 %, ZrCl₄: 0.2 %, N₂: 3%, Al(CH₃)₃: 0%, balance H₂ | 5 | 0.25 | 0.20 | 4.5 | 900 |
| | Zr-C | NH₃: 1.3 %, N₂: 5 %, H₂: 59 %, | 3 | 0.20 | AlCl₃: 0.6 %, TiCl₄: 0.2 %, ZrCl₄: 0.1 %,N₂: 0%, Al(CH₃)₃: 0%, balance H₂ | 3 | 0.20 | 0.15 | 4.5 | 800 |
| | B-A | NH₃: 1.2 %, N₂: 0 %, H₂: 56 %, | 1 | 0.15 | AlCl₃: 0.7 % TiCl₄: 0.3 %, BCl₃: 0.1 %, N₂: 11%, Al(CH₃)₃: 0.2%, balance H₂ | 1 | 0.15 | 0.10 | 5.0 | 800 |
| | B-B | NH₃: 1.4 %, N₂: 3 %, H₂: 59 %, | 2 | 0.15 | AlCl₃: 0.8 %, TiCl₄: 0.2 %, BCl₃: 0.1 %, N₂: 1%, Al(CH₃)₃: 0%, balance H₂ | 2 | 0.15 | 0.10 | 5.0 | 800 |
| | B-C | NH₃: 1.0 %, N₂: 2 %, H₂: 57 % | 4 | 0.20 | AlCl₃: 0.9 %, TiCl₄: 0.3 %, BCl₃: 0.2 %, N₂: 4%, Al(CH₃)₃: | 4 | 0.20 | 0.15 | 4.5 | 750 |
| | | | | | 0%, balance H₂ | | | | | |
| | VA | NR₃: 1.5 %, N₂: 4 %, H₂: 60 %, | 3 | 0.15 | AlCl₃: 0.8 %, TiCl₄: 0.3 %, VCl₄: 0.2 %, N₂: 6%, Al(CH₃)₃: 0%, balance H₂ | 3 | 0.15 | 0.15 | 5.0 | 850 |
| | V-B | NH₃: 1.1 %, N₂: 0 %, H₂: 56 %, | 1 | 0.15 | AlCl₃: 0.7 %, TiCl₄: 0.2 %, VCl₄: 0.1 %, N₂: 5%, Al(CH₃)₃: 0.5%, balance H₂ | 1 | 0.15 | 0.10 | 4.5 | 750 |
| | V-C | NH₃: 1.2 %, N₂: 1 %, H₂: 58 %, | 2 | 0.20 | AlCl₃: 0.6 %, TiCl₄: 0.2 %, VCl₄: 0.1 %, N₂: 0%, Al(CH₃)₃: 0%, balance H₂ | 2 | 0.20 | 0.15 | 5.0 | 800 |
| | Cr-A | NH₃: 1.1 %, N₂: 2 %, H₂: 59 %, | 5 | 0.25 | AlCl₃: 0.9 %, TiCl₄: 0.2 %, CrCl₂: 0.1 %, N₂: 12%, Al(CH₃)₃: 0%, balance H₂ | 5 | 0.25 | 0.20 | 5.0 | 900 |
| | Cr-B | NH₃: 1.4 %, N₂: 0 %, H₂: 56 %, | 3 | 0.20 | AlCl₃: 0.7 %, TiCl₄: 0.3 %, CrCl₂: 0.2 %, N₂: 6%, Al(CH₃)₃: 0%, balance H₂ | 3 | 0.20 | 0.15 | 4.5 | 700 |
| | Cr-C | NH₃: 1.3 %, N₂: 3 %, H₂: 58 %, | 2 | 0.15 | AlCl₃: 0.8 %, TiCl₄: 0.2 %, CrCl₂: 0.1 %, N₂: 1%, Al(CH₃)₃: 0.5%, balance H₂ | 2 | 0.15 | 0.15 | 4.5 | 800 |

**[Table 5]**

| Formation of the hard coating layer | | Formation condition (the composition of the reaction gas indicates the ratio relative to the sum of the gas group A and the gas group B. Units of pressure and temperature of the reaction atmosphere are kPa and °C, respectively) | | | | | | | | |
|---|---|---|---|---|---|---|---|---|---|---|
| Process type | Formation symbol | Composition of the reaction gas group A (volume%) | Gas group A | | Composition of the reaction gas group B (volume%) | Gas group B | | Phase difference of supplying the gas groups A and B (second) | Reaction atmosphere | |
| | | | Supply period (second) | Supply time per a period (second) | | Supply period (second) | Supply time per a period (second) | | Pressure | Temperature |
| | Si-a | NH₃: 0.7 %, N₂: 2 %, H₂: 57 %, | - | - | AlCl₃: 0.9 %, TiCl₄: 0.1 %, SiCl₄: 0.1 %, N₂: 5 %, Al(CH₃)₃: 0 %, balance H₂ | - | - | - | 6.0 | 800 |
| | Si-b | NH₃: 1.3 %, N₂: 0 %, H₂: 64 %, | - | - | AlCl₃: 0.7 %, TiCl₄: 0.2 %, SiCl₄: 0.4 %, N₂: 2 %, Al(CH₃)₃: 0.5 %, balance H₂ | - | - | - | 4.5 | 750 |
| | Si-c | NH₃: 1.1 %, N₂: 1 %, H₂: 59 %, | - | - | AlCl₃: 0.6 %, TiCl₄: 0.5 %, SiCl₄: 0.2 %, N₂: 9 %, Al(CH₃)₃: 0 %, balance H₂ | - | - | - | 4.0 | 850 |
| Comparative deposition process | Zr-a | NH₃: 1.4 %, N₂: 3 %, H₂: 55 %, | - | - | AlCl₃: 1.3 %, TiCl₄: 0.2 %, ZrCl₄: 0.1 %, N₂: 18 %, Al(CH₃)₃: 0 %, balance H₂ | - | - | - | 5.0 | 750 |
| | Zr-b | NH₃: 2.0 %, N₂: 0 %, H₂: 49 %, | - | - | AlCl₃: 0.8 %, TiCl₄: 0.3 %, ZrCl₄: 0.5 %, N₂: 0 %, Al(CH₃)₃: 0.2 %, balance H₂ | - | - | - | 5.0 | 800 |
| | Zr-c | NH₃: 1.0 %, N₂: 7 %, H₂: 59 %, | - | - | AlCl₃: 0.6 %, TiCl₄: 0.3 %, ZrCl₄: 0.1 %, N₂: 14 %, Al(CH₃)₃: 0 %, balance H₂ | - | - | - | 4.5 | 900 |
| | B-a | NH₃: 1.2 %, N₂: 3 %, H₂: 60 %, | - | - | AlCl₃: 0.3 %, TiCl₄: 0.3 %, BCl₃: 0.2 %, N₂: 1 %, Al(CH₃)₃: 0 %, balance H₂ | - | - | - | 6.5 | 950 |
| | B-b | NH₃: 1.8 %, N₂: 1 %, H₂: 58 %, | - | - | AlCl₃: 0.8 %, TiCl₄: 0.3 %, BCl₃: 0.1 %, N₂: 11 %, Al(CH₃)₃: 1.0 %, balance H₂ | - | - | - | 5.0 | 750 |
| | B-c | NH₃: 1.3 %, N₂: 0 %, H₂: 51 %, | - | - | AlCl₃: 0.9 %, TiCl₄: 0.2 %, BCl₃: 0.1 %, N₂: 0 %, Al(CH₃)₃: 0 %, balance H₂ | - | - | - | 4.5 | 650 |
| | V-a | NH₃: 1.1 %, N₂: 4 %, H₂: 56 %, | - | - | AlCl₃: 1.2 %, TiCl₄: 0.1 %, VCl₄: 0.1 %, N₂: 6 %, Al(CH₃)₃: 0.5 %, balance H₂ | - | - | - | 4.5 | 800 |
| | V-b | NH₃: 1.0 %, N₂: 9 %, H₂: 57 %, | - | - | AlCl₃: 0.7 %, TiCl₄: 0.2 %, VCl₄: 0.2 %, N₂: 8 %, Al(CH₃)₃: 0 %, balance H₂ | - | - | - | 3.5 | 600 |
| | V-c | NH₃: 1.5 %, N₂: 3 %, H₂: 60 %, | - | - | AlCl₃: 0.8 %, TiCl₄: 0.3 %, VCl₄: 0.4 %, N₂: 2 %, Al(CH₃)₃: 1.0 %, balance H₂ | - | - | - | 5.0 | 700 |
| | Cr-a | NH₃: 0.5 %, N₂: 1 %, H₂: 57 %, | - | - | AlCl₃: 0.6 %, TiCl₄: 0.2 %, CrCl₂: 0.1 %, N₂: 15 %, Al(CH₃)₃: 0 %, balance H₂ | - | - | - | 4.5 | 800 |
| | Cr-b | NH₃: 1.2%, N₂: 0 %, H₂: 58 %, | - | - | AlCl₃: 0.4 %, TiCl₄: 0.3 %, CrCl₂: 0.1 %, N₂: 10 %, Al(CH₃)₃: 0.2 %, balance H₂ | - | - | - | 5.0 | 950 |
| | Cr-c | NH₃: 1.4 %, N₂: 3 %, H₂: 66 %, | - | - | AlCl₃: 0.9 %, TiCl₄: 0.7 %, CrCl₂: 0.4 %, N₂: 7 %, Al(CH₃)₃: 0 %, balance H₂ | - | - | - | 4.5 | 750 |

**[Table 6]**

| Type | | Hard coating layer (Number at the bottom indicates the intended layer thickness of the layer (µm)) | | | |
|---|---|---|---|---|---|
| | | Lower layer | | Upper layer | |
| | | 1st layer | 2nd layer | 1st layer | 2nd layer |
| | 1 | - | - | - | - |
| | 2 | - | - | - | - |
| | 3 | - | - | - | - |
| | 4 | - | - | - | - |
| | 5 | - | - | - | - |
| | 6 | TiC (0.5) | - | - | - |
| | 7 | TiN (0.3) | - | - | - |
| Coated tools of the present invention, and comparative coated tools | 8 | TiN (0.5) | TiCN (4) | - | - |
| | 9 | TiN (0.3) | TiCN (2) | - | - |
| | 10 | - | - | Al₂O₃ (2.5) | - |
| | 11 | TiN (0.5) | - | TiCN (0.5) | Al₂O₃ (3) |
| | 12 | TiC (1) | - | TiCO (1) | Al₂O₃ (2) |
| | 13 | TiN (0.1) | - | TiCNO (0.3) | Al₂O₃ (1) |
| | 14 | - | - | - | - |
| | 15 | - | - | - | - |

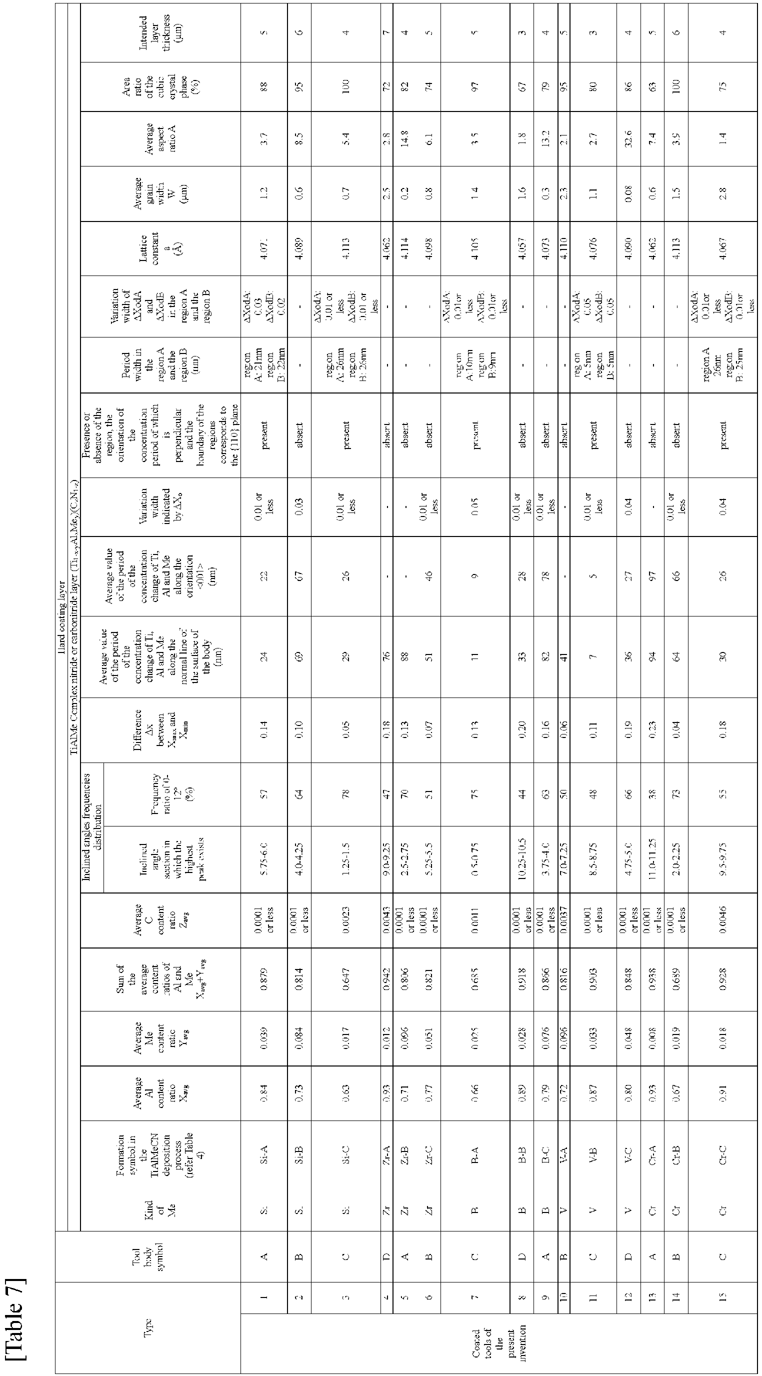

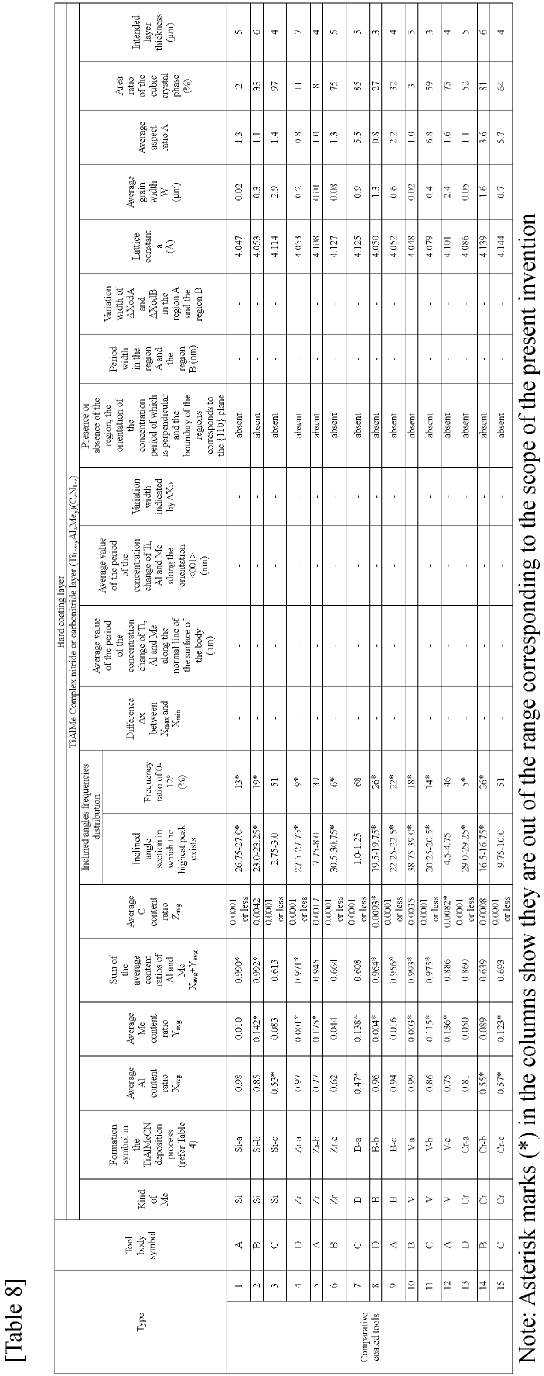

Next, each of the coated tools described above was clamped on the face milling cutter made of tool steel with the cutter diameter of 125 mm by a fixing jig. Then, the cutting test of high-speed-dry-center-cutting-face-milling was performed on the coated tools of the present invention 1-15; and the comparative coated tools 1-15, in the clamped-state. The cutting test of high-speed-dry-center-cutting-face-milling is a type of high speed intermittent cutting of alloy steel, and was performed under the condition shown below. After the test, width of flank wear of the cutting edge was measured.

Tool body: Tungsten carbide-based cemented carbide, titanium carbonitride-based cermet
Cutting test: High speed dry face milling, center cut cutting
Work: Block material with a width of 100 mm and a length of 400 mm of JIS-SCM440
Rotation speed: 891 min⁻¹
Cutting speed: 350 m/min
Depth of cut: 1.5 mm
Feed rate per tooth: 0.2 mm/tooth
Cutting time: 8 minutes

The results of the cutting test are shown in Table 9.

**[Table 9]**

| Type | | Width of wear on the flank face (mm) | Type | | Results of cutting test (min) |
|---|---|---|---|---|---|
| | 1 | 0.15 | | 1 | 2.4* |
| | 2 | 0.17 | | 2 | 3.8* |
| | 3 | 0.14 | | 3 | 6.8* |
| | 4 | 0.19 | | 4 | 2.2* |
| | 5 | 0.16 | | 5 | 3.4* |
| | 6 | 0.14 | | 6 | 5.1* |
| Coated tools of the invention present | 7 | 0.12 | Comparative coated tools | 7 | 4.6* |
| | 8 | 0.11 | | 8 | 3.3* |
| | 9 | 0.12 | | 9 | 5.5* |
| | 10 | 0.10 | | 10 | 2.9* |
| | 11 | 0.09 | | 11 | 6.4* |
| | 12 | 0.14 | | 12 | 7.5* |
| | 13 | 0.15 | | 13 | 6.2* |
| | 14 | 0.18 | | 14 | 4.0* |
| | 15 | 0.12 | | 15 | 6.0* |

Asterisk marks (*) in the column of the coated tools of the comparative examples indicates the cutting time (min) until they reached to their service lives due to occurrence of chipping.

### [Example 2]

As raw material powders, the WC powder, the TiC powder, the ZrC powder, the TaC powder, the NbC powder, the Cr₃C₂ powder, the TiN powder, and the Co powder, all of which had the average grain sizes of 1-3 µm, were prepared. These raw material powders were blended in the blending composition shown in Table 10. Then, wax was added to the blended mixture, and further mixed in acetone for 24 hours with a ball mill. After drying under reduced pressure, the mixtures were press-molded into green compacts with a predetermined shape under pressure of 98 MPa. Then, the obtained green compacts were sintered in vacuum in the condition of 5 Pa vacuum at the predetermined temperature in the range of 1370-1470°C for 1 hour retention. After sintering, the tool bodies α-γ, which had the insert-shape defined by ISO standard CNMG120412 and made of WC-based cemented carbide, were produced by performing honing (R: 0.07mm) on the cutting edge part.

Also, as raw material powders, the TiCN powder (TiC/TiN=50/50 in mass ratio), the NbC powder, the WC powder, the Co powder, and the Ni powder, all of which had the average grain sizes of 0.5-2 µm, were prepared. These raw material powders were blended in the blending composition shown in Table 11. Then, the mixtures were wet-mixed for 24 hours with a ball mill. After drying, the mixtures were press-molded into green compacts under pressure of 98 MPa. The, the obtained green compacts were sintered in nitrogen atmosphere of 1.3 kPa at 1500°C for 1 hour retention. After sintering, the tool bodyδ, which had the insert-shape defined by ISO standard CNMG120412 and made of TiCN-based cermet, was produced by performing honing (R: 0.09mm) on the cutting edge part.

Next, the coated tools of the present invention 16-30 were produced by performing the thermal CVD method in the formation condition shown in Table 4 for predetermined times to deposit the (Ti_{l-x-y}AlₓMe_{y})(C_{z}N_{l-z}) layers shown in Table 13 on the surfaces of the tool bodies α to γ and the tool body δ by using a chemical vapor deposition apparatus as in Example 1.

In regard to the coated tools of the present invention 19-28, the lower layer and/or the upper layer were formed as shown in Table 12 in the formation condition shown in Table 3.

For comparison purposes, the comparative coated tools 16-30 indicated in Table 14 were deposited the hard coating layer on the surface of the tool bodies α-γ and the tool body δ in intended thicknesses shown in Table 14 using a chemical vapor deposition apparatus in the conditions indicated in Tables 5 in the same manner.

Similarly to the coated tools of the present invention 19-28, in regard to the coated tools of comparative coated cutting tools 19-28, the lower layer and/or the upper layer shown in Table 12 were formed in the forming condition shown in Table 3.

In regard to the coated tools of the present invention 16-30; and the comparative coated tools 16-30, the cross sections of each constituting layers were subjected to measurement by the scanning electron microscopy (magnification: 20,000); and the average layer thicknesses were obtained by averaging the layer thicknesses measured at 5 points within the observation viewing field. In any measurement, the obtained layer thickness was practically the same as the intended total layer thicknesses shown in Tables 13 and 14.

In addition, in regard to the hard coating layers of the coated tools of the present invention 16-30; and the comparative coated tools 16-30, the average Al content ratio X_{avg}; the average Me content ratio Y_{avg}; the average C content ratio Z_{avg}; the inclined angle frequency distribution; the difference Δx of the periodical concentration change (=Xₘₐₓ-Xₘᵢₙ) and the period; the lattice constant "a"; the average grain width W and the average aspect ratio A of the crystal grains; and the area ratio occupied by the cubic crystal phase in the crystal grains, were obtained by using the same methods indicated in Example 1.

Results were indicated in Tables 13 and 14.

**[Table 10]**

| Type | | Blending composition (mass%) | | | | | | | |
|---|---|---|---|---|---|---|---|---|---|
| | | Co | TiC | ZrC | TaC | NbC | Cr₃C₂ | TiN | WC |
| Tool body | α | 6.5 | - | 1.5 | - | 2.9 | 0.1 | 1.5 | balance |
| | β | 7.6 | 2.6 | - | 4.0 | 0.5 | - | 1.1 | balance |
| | γ | 6.0 | - | - | - | - | - | - | balance |

**[Table 11]**

| Type | | Blending composition (mass%) | | | | |
|---|---|---|---|---|---|---|
| | | Co | Ni | NbC | WC | TiCN |
| Tool body | δ | 11 | 4 | 6 | 15 | balance |

**[Table 12]**

| Type | | Lower layer (The number at the bottom indicates the intended average layer thickness (µm)) | | | | Upper layer (The number at the bottom indicates the intended average layer thickness (µm)) | | | |
|---|---|---|---|---|---|---|---|---|---|
| | | 1st layer | 2nd layer | 3rd layer | 4th layer | 1st layer | 2nd layer | 3rd layer | 4th layer |
| Coated tools of the present invention and comparative coated tools | 16 | - | - | - | - | - | - | - | - |
| | 17 | - | - | - | - | - | - | - | - |
| | 18 | - | - | - | - | - | - | - | - |
| | 19 | TiC (0.5) | - | - | - | - | - | - | - |
| | 20 | TiN (0.1) | - | - | - | - | - | - | - |
| | 21 | TiN (0.5) | TiCN (7) | - | - | - | - | - | - |
| | 22 | TiN (0.3) | TiCN (10) | TiN (0.7) | - | TiN (0.7) | - | - | - |
| | 23 | TiN (0.3) | TiCN (4) | TiCN (0.4) | TiN (0.3) | TiCN (0.4) | TiN (0.3) | - | - |
| | 24 | - | - | - | - | Al₂O₃ (4) | - | - | - |
| | 25 | TiN (0.5) | - | - | - | TiCN (0.5) | Al₂O₃ (5) | - | - |
| | 26 | TiC (1) | - | - | - | TiCO (1) | Al₂O₃ (2) | - | - |
| | 27 | TiN (0.1) | - | - | - | TiCNO (0.3) | Al₂O₃ (1) | - | - |
| | 28 | TiN (0.1) | - | - | - | TiN (0.3) | TiCN (0.8) | TiCNO (0.3) | Al₂O₃ (5) |
| | 29 | - | - | - | - | - | - | - | - |
| | 30 | - | - | - | - | - | - | - | - |

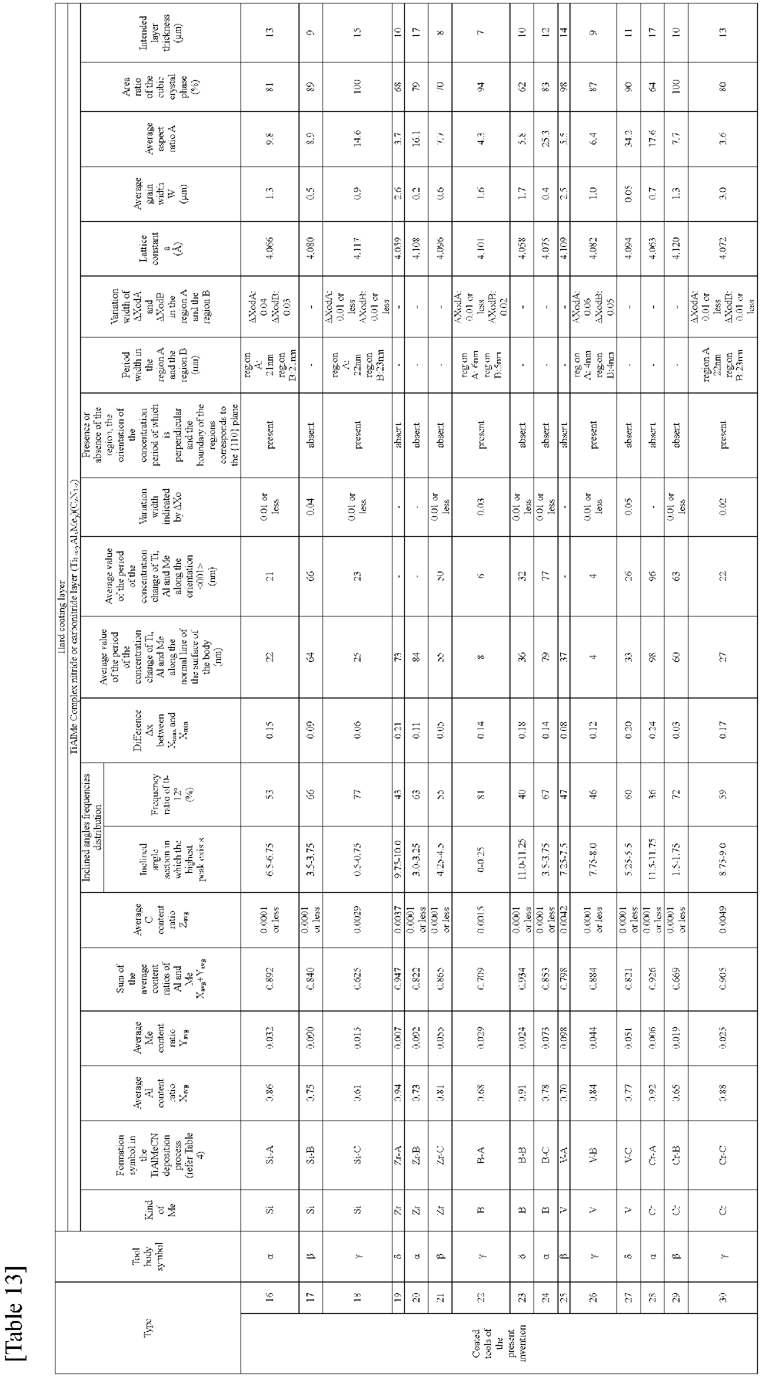

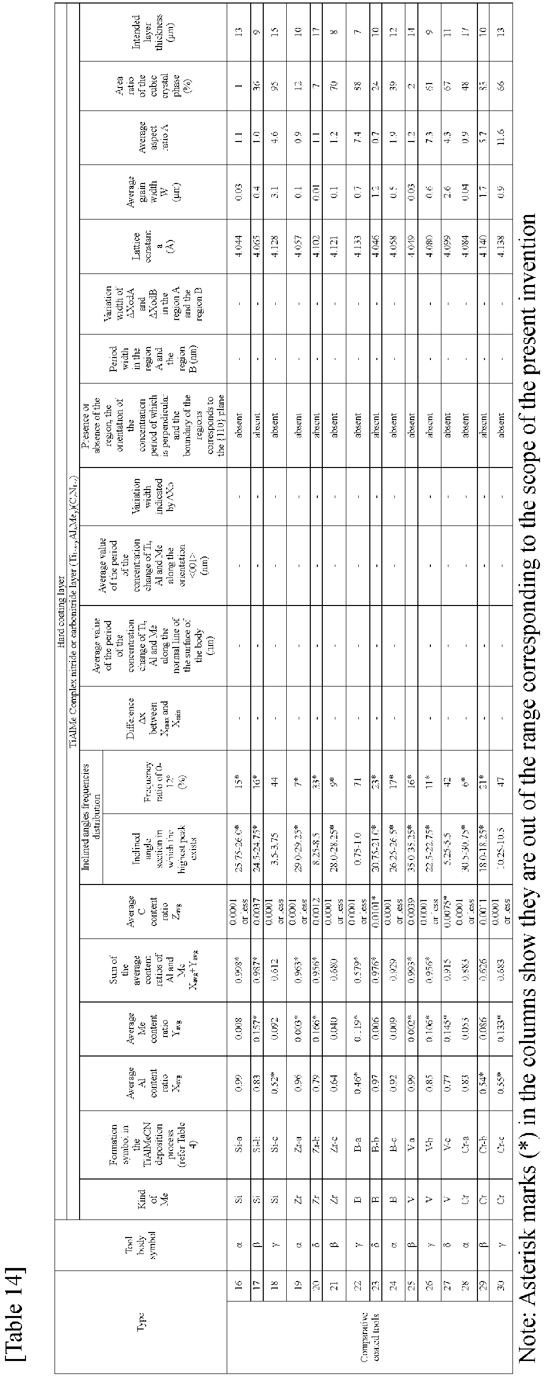

Next, each of the coated tools described above was clamped on the front end part of the bit made of tool steel by a fixing jig. Then, the dry high-speed intermittent cutting test on alloy steel and the wet high-speed intermittent cutting test on a cast iron were performed on the coated tools of the present invention 16-30; and the comparative coated tools 16-30, in the clamped-state. After the test, width of flank wear of the cutting edge was measured.
Cutting condition 1:
   Work: Round bar with 4 longitudinal grooves formed at equal intervals in the longitudinal direction of JIS-SCM45C
   Cutting speed: 380 m/min.
   Depth of cut: 1.5 mm
   Feed rate: 0.2 mm/rev.
   Cutting time: 5 minutes
   (the normal cutting speed is 220 m/min)
Cutting condition 2:
   Work: Round bar with 4 longitudinal grooves formed at equal intervals in the longitudinal direction of JIS FCD700
   Cutting speed: 325 m/min.
   Depth of cut: 1.2 mm
   Feed rate: 0.1 mm/rev.
   Cutting time: 5 minutes
   (the normal cutting speed is 200 m/min)

The results of the cutting tests are shown in Table 15.

**[Table 15]**

| Type | | Width of wear on the flank face (mm) | | Type | | Results of the cutting test (min) | |
|---|---|---|---|---|---|---|---|
| | | Cutting condition 1 | Cutting condition 2 | | | Cutting condition 1 | Cutting condition 2 |
| Coated tools of the present invention | 16 | 0.17 | 0.19 | Comparative coated tools | 16 | 1.9* | 1.5* |
| | 17 | 0.19 | 0.18 | | 17 | 2.4* | 2.7* |
| | 18 | 0.15 | 0.14 | | 18 | 4.4* | 4.1* |
| | 19 | 0.20 | 0.19 | | 19 | 1.7* | 1.4* |
| | 20 | 0.18 | 0.18 | | 20 | 2.6* | 2.2* |
| | 21 | 0.16 | 0.14 | | 21 | 3.6* | 3.9* |
| | 22 | 0.12 | 0.10 | | 22 | 3.8* | 4.2* |
| | 23 | 0.17 | 0.16 | | 23 | 2.8* | 3.1* |
| | 24 | 0.15 | 0.14 | | 24 | 3.0* | 2.5* |
| | 25 | 0.11 | 0.10 | | 25 | 2.3* | 2.0* |
| | 26 | 0.14 | 0.15 | | 26 | 4.1* | 3.8* |
| | 27 | 0.15 | 0.16 | | 27 | 4.8* | 4.5* |
| | 28 | 0.16 | 0.16 | | 28 | 3.7* | 3.3* |
| | 29 | 0.18 | 0.19 | | 29 | 2.5* | 2.1* |
| | 30 | 0.14 | 0.13 | | 30 | 3.4* | 3.2* |

Asterisk marks (*) in the column of the comparative coated tools indicate the cutting time (min) until they reached to their service lives due to occurrence of chipping.

### [Example 3]

The tool bodies 2A and 2B were produced by the process explained below. First, as raw material powders, the cBN powder, the TiN powder, the TiCN powder, the TiC powder, the Al powder, and Al₂O₃ powder, all of which had the average grain sizes of 0.5-4 µm, were prepared. These raw material powders were blended in the blending composition shown in Table 16. Then, the mixtures were wet-mixed for 80 hours with a ball mill. After drying, the mixtures were press-molded into green compacts with a dimension of: diameter of 50 mm; and thickness of 1.5 mm, under pressure of 120 MPa. Then, the obtained green compacts were sintered in vacuum in the condition of 1 Pa vacuum at the predetermined temperature in the range of 900-1300°C for 60 minutes retention to obtain preliminary sintered bodies for the cutting edge pieces. The obtained preliminary sintered bodies were placed on separately prepared supporting pieces made of WC-based cemented carbide, which had the composition of: 8 mass% of Co; and the WC balance, and the dimension of: diameter of 50 mm; and thickness of 2 mm. They were inserted into a standard ultra-high pressure sintering apparatus in the stacked state. Then, they were subjected to ultra-high-pressure sintering in the standard condition of: 4 GPa of pressure; a predetermined temperature within the range of 1200-1400°C; and 0.8 hour of the retention time. Then, the top and bottom surfaces of the sintered bodies were grinded by using a diamond grind tool. Then, they were divided into a predetermined dimension with a wire-electrical discharge machine. Then, they were brazed on the brazing portion (corner portion) of the insert main tool body made of WC-based cemented carbide, which had the composition of: 5 mass% of Co; 5 mass% of TaC; and the WC balance, and the shape defined by ISO CNGA120412 standard (the diamond shape of: thickness of 4.76 mm; and inscribed circle diameter of 12.7 mm) by using the brazing material made of Ti-Zr-Cu alloy having composition made of: 37.5% of Zr; 25% of Cu; and the Ti balance in volume %. Then, after performing outer peripheral machining into a predetermined dimension, the cutting edges of the brazed parts were subjected to a honing work of: width of 0.13 mm; and angle of 25°. Then, by performing the final polishing on them, the tool bodies 2A and 2B with the insert shape defined by ISO CNGA120412 standard were produced.

**[Table 16]**

| Type | | Blending composition (mass%) | | | | |
|---|---|---|---|---|---|---|
| | | TiN | TiC | Al | Al₂O₃ | cBN |
| Tool body | 2A | 50 | - | 5 | 3 | balance |
| | 2B | - | 50 | 4 | 3 | balance |

Next, the coated tools of the present invention 31-40 indicated in Tables 18 were deposited the hard coating layer including at least the (Ti_{1-x-y}AlₓMe_{y})(C_{z}N_{1-z}) layer related to the present invention on the surfaces of the tool bodies 2A and 2B in the intended layer thicknesses using a chemical vapor deposition apparatus in the conditions indicated in Table 4 as in the same method as Example 1.

In regard to the coated tools of the present invention 34-39, the lower layer and/or the upper layer shown in Table 17 were formed in the formation condition shown in Table 3.

For comparison purposes, the comparative coated tools 31-40 indicated in Table 19 were deposited the hard coating layer including at least the (Ti_{1-x-y}AlₓMey)(C_{z}N_{1-z}) layer on the surface of the tool bodies 2A and 2B in intended thicknesses using a chemical vapor deposition apparatus in the conditions indicated in Table 5.

As in the coated tools of the present invention 34-39, the lower layer and/or the upper layer shown in Table 17 were formed in the formation conditions shown in Table 3 in the comparative coated tools 34-39.

Cross sections of each constituent layer of the coated tools of the present invention 31-40; and the comparative coated tools 31-40, were subjected to measurement by using a scanning electron microscope (magnification: 5,000 times), and the layer thicknesses were obtained by averaging layer thicknesses measured at 5 points within the observation viewing field. In any measurement, the obtained layer thickness was practically the same as the intended total layer thicknesses shown in Tables 18 and 19.

In regard to the hard coating layer of the coated tools of the present invention 31-40; and the comparative coated tools 31-40, the average layer thicknesses; the average Al content ratio X_{avg}; the average Me content ratio Y_{avg}; the average C content ratio Z_{avg}; the inclined angle frequency distribution; the difference Δx of the periodical concentration change (=Xₘₐₓ-Xₘᵢₙ) and the period; the lattice constant "a"; the average grain width W and the average aspect ratio A of the crystal grains; and the area ratio occupied by the cubic crystal phase in the crystal grains, were obtained as in the method indicated in Example 1.

The measurement results are shown in Tables 18 and 19.

**[Table 17]**

| Type | | Tool body symbol | Lower layer (The number at the bottom indicates the intended average layer thickness (µm)) | | | Upper layer (The number at the bottom indicates the intended average layer thickness (µm)) |
|---|---|---|---|---|---|---|
| | | | 1st layer | 2nd layer | 3rd layer | 1st layer |
| Coated tools of the present invention and comparative coated tools | 31 | 2A | - | - | - | - |
| | 32 | 2B | - | - | - | - |
| | 33 | 2A | - | - | - | - |
| | 34 | 2B | - | - | - | TiN (0.5) |
| | 35 | 2A | TiN (0.5) | - | - | - |
| | 36 | 2B | TiN (0.3) | - | - | - |
| | 37 | 2A | TiN (0.5) | TiCN (1) | - | - |
| | 38 | 2B | TiN (0.3) | TiCN (2) | TiN (0.5) | - |
| | 39 | 2A | - | - | - | TiN (0.5) |
| | 40 | 2B | - | - | - | - |

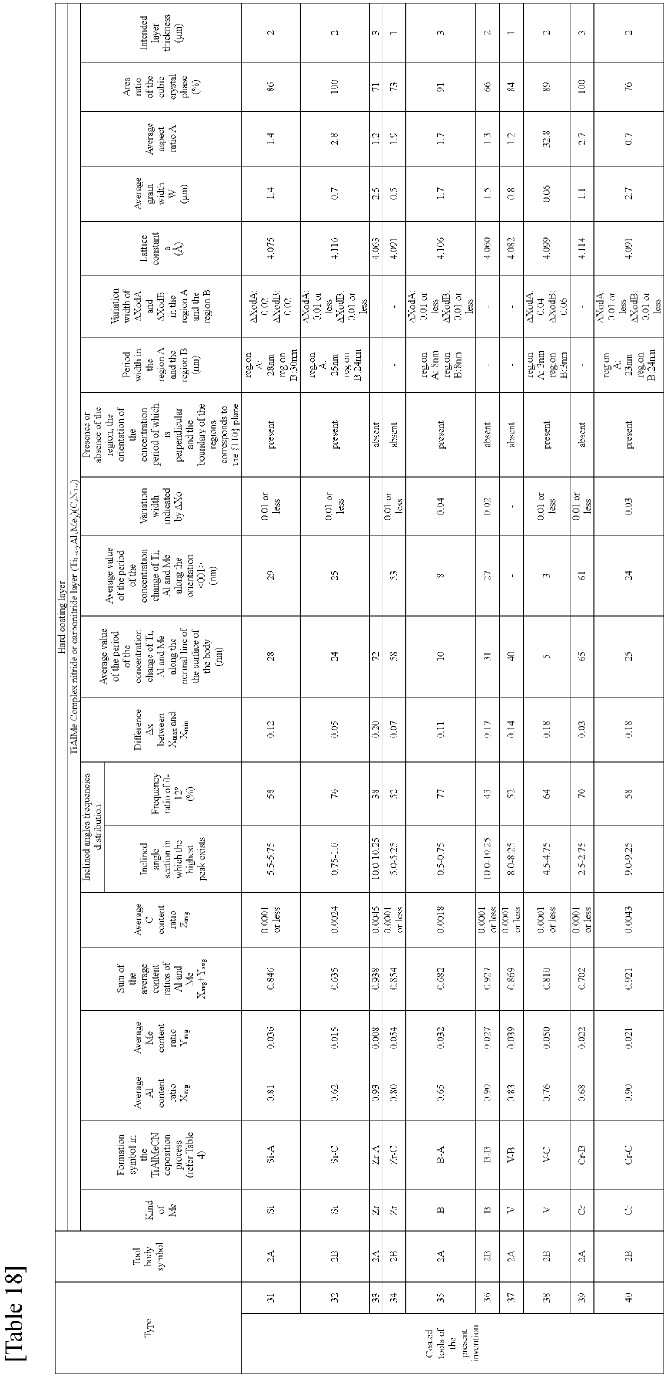

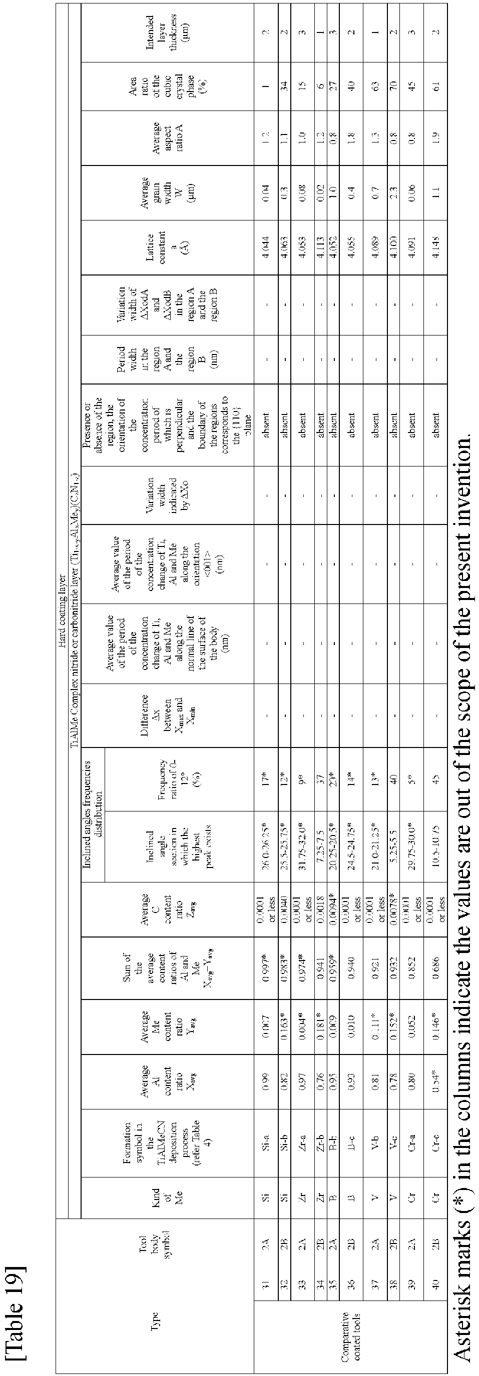

Next, each coated tool was screwed on the tip of the insert holder made of tool steel by a fixing jig. Then, the dry high speed intermittent cutting test of carbolized steel explained below were performed on the coated tools of the present invention 31-40; and the comparative coated tools 31-40. After the tests, width of flank wear of the cutting edge was measured.
Cutting test: Dry high-speed intermittent cutting of a carbolized steel
Work: Round bar with 4 longitudinal grooves formed at equal intervals in the longitudinal direction of JIS SCr420 (hardness: HRC62)
Cutting speed: 255 m/min.
Depth of cut: 0.1 mm
Feed rate: 0.1 mm/rev.
Cutting time: 4 minutes

Results of the cutting test are shown in Table 20.

**[Table 20]**

| Type | | Width of wear on the flank face (mm) | Type | | Results of the cutting test (min) |
|---|---|---|---|---|---|
| Coated tools of the present invention | 31 | 0.11 | Comparative coated tools | 31 | 1.7* |
| | 32 | 0.09 | | 32 | 2.2* |
| | 33 | 0.13 | | 33 | 1.5* |
| | 34 | 0.10 | | 34 | 2.9* |
| | 35 | 0.08 | | 35 | 1.8* |
| | 36 | 0.11 | | 36 | 2.0* |
| | 37 | 0.09 | | 37 | 2.9* |
| | 38 | 0.12 | | 38 | 3.3* |
| | 39 | 0.11 | | 39 | 2.8* |
| | 40 | 0.07 | | 40 | 3.1* |

Asterisk marks (*) in the column of the comparative coated tools indicate the cutting time (min) until they reached to their service lives due to occurrence of chipping.

### [Example 4]

As in Example 1, the tool bodies A to C made of WC-based cemented carbide were deposited by the process in which, as raw material powders, the WC powder, the TiC powder, the TaC powder, the NbC powder, the Cr₃C₂ powder, and Co powder, all of which had the average grain sizes of 1-3 µm, were prepared. These raw material powders were blended in the blending composition shown in Table 1. Then, the mixtures were subjected ball mill mixing for 24 hours in acetone after adding wax. After vacuum drying, the mixtures were press-molded into green compacts in the predetermined shape at the pressure of 98MPa. Then, the obtained green compacts were sintered in vacuum in the condition of 5 Pa vacuum at the predetermined temperature in the range of 1370 °C-1470°C for retention time of 1 hour. After sintering, the tool bodies A to C made of WC-based cemented carbide with the insert shape defined by ISO SEEN1203AFSN standard were produced.

Next, as in Example 1, the coated tools of the present invention 41-55 were deposited the (Ti_{1-x-y}AlₓMe_{y})(C_{z}N_{1-z}) layer shown in Table 23 on the surfaces of the tool bodies A to C by performing a thermal CVD method for a predetermined time in the formation condition shown in Table 4 with a chemical vapor deposition apparatus.

In regard to the coated tools of the present invention 45-52, the lower layer and/or the upper layer shown in Table 22 were formed in the formation condition shown in Table 3.

For comparison purposes, the comparative coated tools 41-55 indicated in Table 24 were deposited the hard coating layer on the surfaces of the tool bodies A to C too as in the coated tools of the present invention by using a chemical vapor deposition apparatus in the condition shown in Table 21 and in the intended layer thickness shown in Table 24.

As in the coated tools of the present invention 45-52, the lower layer and/or the upper layer shown in Table 22 were formed in the formation conditions shown in Table 3 in the comparative coated tools 45-52.

Cross sections of each constituent layer of the coated tools of the present invention 41-55; and the comparative coated tools 41-55, were subjected to measurement by using a scanning electron microscope (magnification: 5,000 times), and the layer thicknesses were obtained by averaging layer thicknesses measured at 5 points within the observation viewing field. In any measurement, the obtained layer thickness was practically the same as the intended total layer thicknesses shown in Tables 23 and 24.

In regard to the hard coating layer of the coated tools of the present invention 41-55; and the comparative coated tools 41-55, the average Al content ratio X_{avg}; the average Me content ratio Y_{avg}; the average C content ratio Z_{avg}; the inclined angle frequency distribution; the difference Δx of the periodical concentration change (=Xₘₐₓ-Xₘᵢₙ) and the period; the lattice constant "a"; the average grain width W and the average aspect ratio A of the crystal grains; and the area ratio occupied by the cubic crystal phase in the crystal grains, were obtained as in the method indicated in Example 1.

The measurement results are shown in Tables 23 and 24.

**[Table 21]**

| Formation of the hard coating layer | | Formation condition (the composition of the reaction gas indicates the ratio relative to the sum of the gas group A and the gas group B. Units of pressure and temperature of the reaction atmosphere are kPa and °C, respectively) | | | | | | | | |
|---|---|---|---|---|---|---|---|---|---|---|
| Process type | Formation symbol | Composition of the reaction gas group A (volume%) | Gas group A | | Composition of the reaction gas group B (volume%) | Gas group B | | Phase difference of supplying the gas groups A and B (second) | Reaction atmosphere | |
| | | | Supply period (second) | Supply time per a period (second) | | Supply period (second) | Supply time per a period (second) | | Pressure | Temperature |
| | Si-d | NH₃: 1.3 %, N₂: 10 %, H₂: 57 %, | 4 | 0.20 | AlCl₃: 0.7 %, TiCl₄: 0.3 %, SiCl₄: 0.4 %, N₂: 4 %, Al(CH₃)₃: 0 %, balance H₂ | 4 | 0.20 | 0.15 | 5.0 | 950 |
| | Si-e | NH₃: 1.0 %, N₂: 2 %, H₂: 65 %, | 3 | 0.15 | AlCl₃: 0.4 %, TiCl₄: 0.3 %, SiCl₄: 0.1 %, N2: 0 %, Al(CH₃)₃: 0 %, balance H₂ | 3 | 0.15 | 0.15 | 4.0 | 800 |
| | Si-f | NH₃: 1.5 %, N₂: 0 %, H₂: 55 %, | 8 | 0.40 | AlCl₃: 0.6 %, TiCl₄: 0.2 %, SiCl₄: 0.1 %, N2: 9 %, Al(CH₃)₃: 0 %, balance H₂ | 8 | 0.40 | 0.35 | 4.7 | 850 |
| | Zr-d | NH₃: 1.2 %, N₂: 4 %, H₂: 50 %, | 1 | 0.15 | AlCl₃: 0.8 %, TiCl₄: 0,3 %, ZrCl₄: 0.2 %, N₂: 3 %, Al(CH₃)₃: 0.5 %, balance H₂ | 1 | 0.15 | 0.05 | 4.5 | 600 |
| Deposition process | Zr-e | NH₃: 0.8 %, N₂: 0 %, H₂: 58 %, | 1 | 0.10 | AlCl₃ 0.9 %, TiCl₄: 0.2 %, ZrCl₄: 0.1 %, N₂: 10 %, Al(CH₃)₃: 0 %, balance H₂ | 1 | 0.10 | 0.05 | 4.5 | 750 |
| | Zr-f | NH₃: 1.3 %, N₂: 8 %, H₂: 60 %, | 3 | 0.20 | AlCl₃: 0.6 %, TiCl₄: 0,3 %, ZrCl₄: 0.05 %, N₂: 1 %, Al(CH₃)₃: 0 %, balance H₂ | 3 | 0.20 | 0.15 | 6.0 | 900 |
| | B-d | NH₃: 1.4 %, N2: 3 %, H₂: 56 %, | 10 | 0.50 | AlCl₃: 0.8 %, TiCl₄: 0.2 %, BCl₃: 0.2 %, N₂: 7 %, | 10 | 0.50 | 0.40 | 4.7 | 800 |
| | | | | | Al(CH₃)₃: 0.2 %, balance H₂ | | | | | |
| | B-e | NH₃: 1.8 %, N₂: 1 %, H₂: 55 %, | 2 | 0.15 | AlCl₃: 0.7 %, TiCl₄: 0.2 %, BCl₃: 0,1 %, N₂: 15 %, Al(CH₃)₃: 1.0 %, balance H₂ | 2 | 0.15 | 0.10 | 5.0 | 700 |
| | B-f | NH₃: 1.1 %, N₂: 0 %, H₂: 59 %, | 4 | 0.25 | AlCl₃: 1.1 %, TiCl₄: 0.1 %, BCl₃: 0.2 %, N₂: 6 %, Al(CH₃)₃: 0 %, balance H₂ | 4 | 0.25 | 0.20 | 4.5 | 850 |
| | V-d | NH₃: 1.5 %, N₂: 5 %, H₂: 52 %, | 5 | 0.25 | AlCl₃: 0.7 %, TiCl₄: 0,3 %, VCl₄: 0.04 %, N₂: 11 %, Al(CH₃)₃: 0 %, balance H₂ | 5 | 0.25 | 0.20 | 3.5 | 800 |
| | V-e | NH₃: 1.2 %, N₂: 2 %, H₂: 59 %, | 1 | 0.10 | AlCl₃: 0.9 %, TiCl₄: 0.3 %, VCl₄: 0.2 %, N₂: 8 %, Al(CH₃)₃: 0.8 %, balance H₂ | 1 | 0.10 | 0.25 | 4.7 | 700 |
| | V-f | NH₃: 0.6 %, N₂: 7%, H₂: 57 %, | 2 | 0.15 | AlCl₃: 0.6 %, TiCl₄: 0.3 %, VCl₄: 0.1 %, N₂: 18 %, Al(CH₃)₃: 0 %, balance H₂ | 2 | 0.15 | 0.10 | 5.5 | 650 |
| | Cr-d | NH₃: 2.0 %, N₂: 3 %, H₂: 63 %, | 4 | 0.25 | AlCl₃: 0.8 %, TiCl₄: 0.3 %, CrCl₂: 0.2 %, N₂: 0 %, Al(CH₃)₃: 0 %, balance H₂ | 4 | 0.25 | 0.30 | 4.5 | 800 |
| | Cr-e | NH₃: 1.4%, N₂: 4 %, H₂: 58 %, | 3 | 0.20 | AlCl₃: 0.6 %, TiCl₄: 0.5 %, CrCl₂: 0.1 %, N₂: 2 %, Al(CH₃)₃: 0 %, balance H₂ | 3 | 0.20 | 0.15 | 5.0 | 950 |
| | Cr-f | NH₃: 1.0 %, N₂: 0 %, H₂: 56 %, | 7 | 0.35 | AlCl₃: 0.7 %, TiCl₄: 0.3 %, CrCl₂: 0.3 %, N₂: 3 %, Al(CH₃)₃: 0 %, balance H₂ | 7 | 0.35 | 0.20 | 4.5 | 750 |

**[Table 22]**

| Type | | Hard coating layer (The number at the bottom indicates the intended average layer thickness (µm)) | | | |
|---|---|---|---|---|---|
| | | Lower layer | | Upper layer | |
| | | 1st layer | 2nd layer | 1st layer | 2nd layer |
| | 41 | - | - | - | - |
| | 42 | - | - | - | - |
| | 43 | - | - | - | - |
| | 44 | - | - | - | - |
| | 45 | TiC (0.5) | - | - | - |
| | 46 | TiN (0.5) | - | - | - |
| Coated tools of the present invention and comparative coated tools | 47 | TiN (0.3) | TiCN (1) | - | - |
| | 48 | TiN (0.3) | TiCN (2) | - | - |
| | 49 | - | - | TiCN (0.3) | Al₂O₃ (1) |
| | 50 | TiN (0.3) | TiCN (1) | TiCN (0.5) | Al₂O₃ (2) |
| | 51 | TiC (0.5) | - | TiCO (0.3) | Al₂O₃ (2) |
| | 52 | TiN (0.5) | TiCN (1) | TiCNO (0.3) | Al₂O₃ (1) |
| | 53 | - | - | - | - |
| | 54 | - | - | - | - |
| | 55 | - | - | - | - |

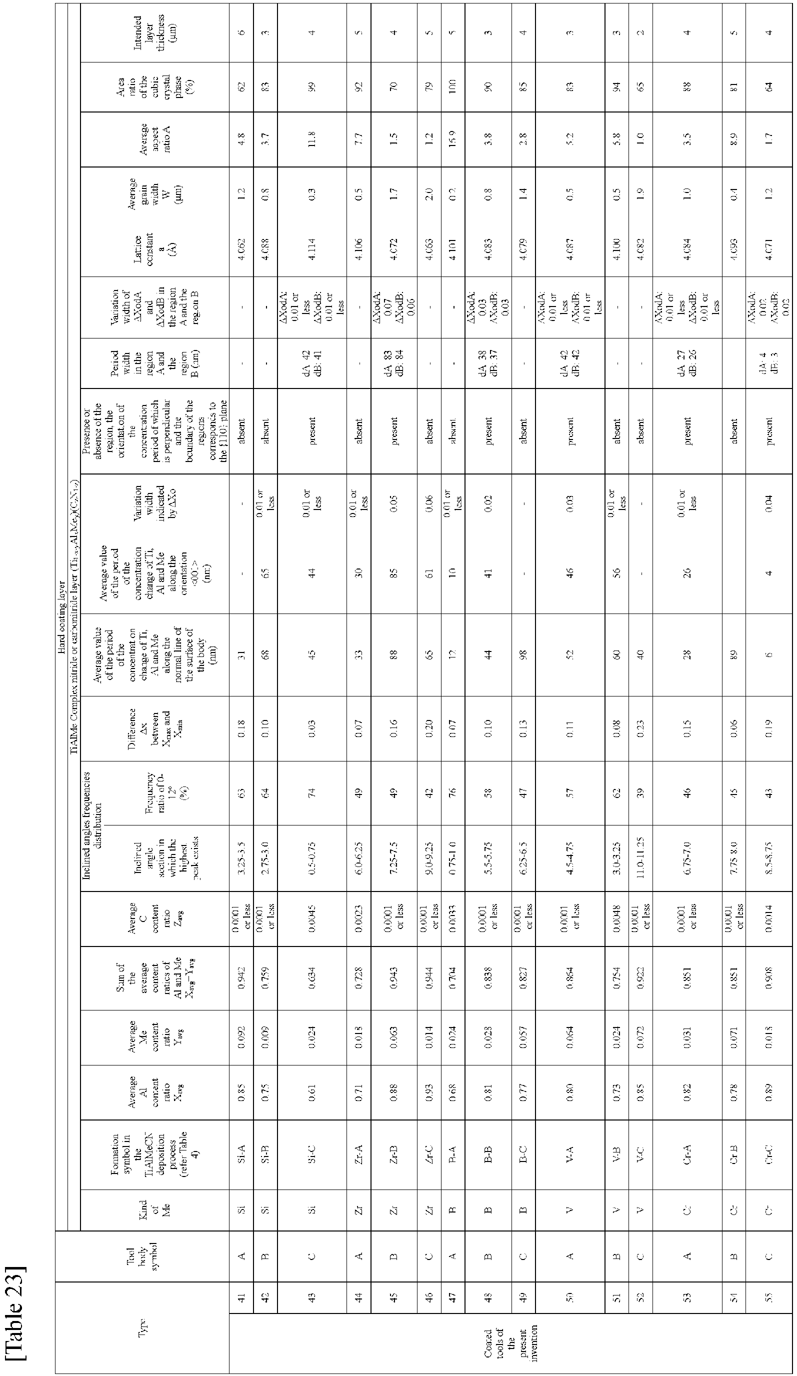

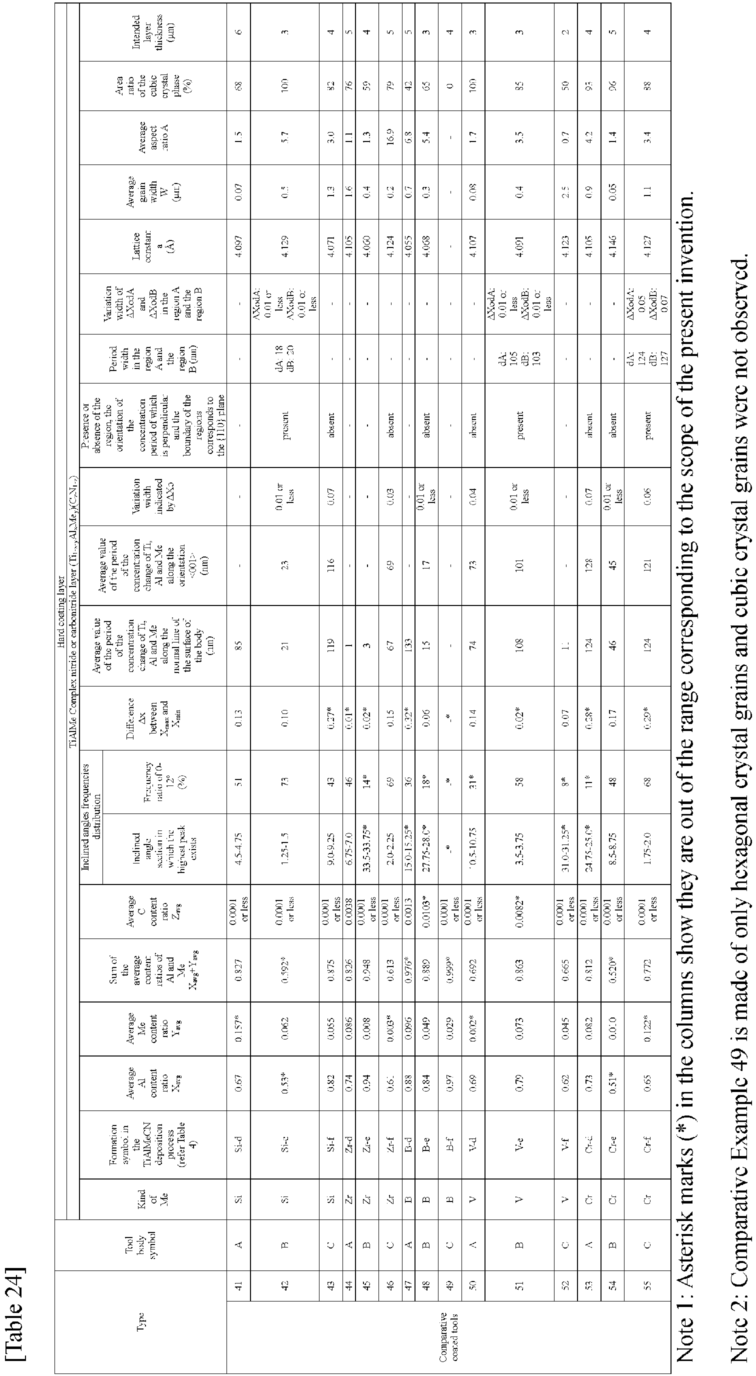

Next, each coated tool was clamped on the tip of the cutter made of tool steel with the cutter diameter of 125 mm by a fixing jig. Then, center cut cutting test in high speed wet face milling, which is one of high speed intermittent cutting of carbolized steel, was performed on the coated tools of the present invention 41-55; and the comparative coated tools 41-55 in the condition described below. After the tests, width of flank wear of the cutting edge was measured.

Tool body: Tungsten carbide-based cemented carbide
Cutting test: Center cut cutting test in high speed wet face milling
Work: Block material with a width of 100 mm and a length of 400 mm of JIS-S55C
Rotation speed: 891 min⁻¹
Cutting speed: 350 m/min
Depth of cut: 2.0 mm
Feed rate per a teeth: 0.2 mm/teeth.
Coolant: Applied
Cutting time: 5 minutes

Results of the cutting test are shown in Table 25.

**[Table 25]**

| Type | | Width of wear on the flank face (mm) | Type | | Results of the cutting test (min) |
|---|---|---|---|---|---|
| | 41 | 0.15 | | 41 | 4.0* |
| | 42 | 0.18 | | 42 | 3.8* |
| | 43 | 0.19 | | 43 | 4.5* |
| | 44 | 0.18 | | 44 | 4.7* |
| | 45 | 0.14 | | 45 | 2.8* |
| Coated tools of the present invention | 46 | 0.12 | Comparative coated tools | 46 | 4.3* |
| | 47 | 0.17 | | 47 | 2.1* |
| | 48 | 0.16 | | 48 | 2.4* |
| | 49 | 0.13 | | 49 | 1.6* |
| | 50 | 0.10 | | 50 | 3.6* |
| | 51 | 0.16 | | 51 | 3.1* |
| | 52 | 0.11 | | 52 | 2.9* |
| | 53 | 0.12 | | 53 | 2.3* |
| | 54 | 0.18 | | 54 | 3.2* |
| | 55 | 0.13 | | 55 | 2.6* |

Asterisk marks (*) in the column of the comparative coated tools indicate the cutting time (min) until they reached their service lives due to occurrence of chipping.

Based on the results shown in Tables 9, 15, 20 and 25, it was demonstrated that hardness was improved due to the strain in the crystal grains and toughness was improved too while keeping a high wear resistance in the coated tool of the present invention by: the cubic crystal grain showing the {111} plane orientation in the hard coating layer including at least the cubic crystal grain of the Ti, Al and Me complex nitride or carbonitride layer; the crystal grains being in the columnar structure; and the concentration change of Ti, Al and Me existing in the crystal grains. In addition, the surface coated cutting tools of the present invention showed an excellent chipping resistance and an excellent fracture resistance even if they were used in high speed intermittent cutting. It is clear that they exhibited an excellent wear resistance for a long-term usage because of these.

Contrary to that, it was clear that comparative coated tools reached to their service lives in a short period of time due to occurrence of chipping, fracture, or the like when they were used in the high speed intermittent cutting in which intermittent and impacting high load exerts on the cutting edge, since the technical features defined in the scope of the present invention were not satisfied in their hard coating layers including at least the cubic crystal grain of Ti, Al and Me complex nitride or carbonitride layers constituting the hard coating layers.

### INDUSTRIAL APPLICABILITY

The coated tool of the present invention can be utilized in high speed intermittent cutting of a wide variety of works as well as of alloy steel as described above. Furthermore, the coated tool of the present invention exhibits an excellent chipping resistance and an excellent wear resistance for a long-term usage. Thus, the coated tool of the present invention can be sufficiently adapted to high-performance cutting apparatuses; and labor-saving, energy-saving, and cost-saving of cutting.

### BRIEF DESCRIPTION OF THE REFERENCE SYMBOLS

1: Hard coating layer
2: Complex nitride or carbonitride layer made of Ti, Al and Me
3: Tool body
4: Surface of the body (polished face of the surface of the tool body)
5: Normal line of the surface of the body (polished face of the surface of the tool body)
6: Normal line of the {111} plane
7: Inclined angle of the {111} plane: 0°
8: Inclined angle of the {111} plane: 45°
9: Region in which Al content amount is relatively high
10: Region in which Al content amount is relatively low
11 a: Local maximum 1
11b: Local maximum 2
11c: Local maximum 3
12a: Local minimum 1
12b: Local minimum 2
12c: Local minimum 3
12d: Local minimum 4
13: Region A
14: Region B
15: Boundary of the region A and the region B

## Claims

1. A surface coated cutting tool comprising: a tool body made of any one of tungsten carbide-based cemented carbide, titanium carbonitride-based cermet, and cubic boron nitride-based ultra-high pressure sintered material; and a hard coating layer formed on a surface of the tool body, wherein
(a) the hard coating layer comprises at least a Ti, Al and Me complex nitride or carbonitride layer having an average layer thickness of 1 µm to 20 µm, Me being an element selected from Si, Zr, B, V, and Cr,
in a case where a composition of the complex nitride or carbonitride layer is expressed by a composition formula: (Ti_{l-x-y}AlₓMe_{y})(C_{z}N_{l-z}), an average content ratio X_{avg}, which is a ratio of Al to a total amount of Ti, Al and Me in the complex nitride or carbonitride layer; an average content ratio Y_{avg}, which is a ratio of Me to the total amount of Ti, Al and Me in the complex nitride or carbonitride layer; and an average content ratio Z_{avg}, which is a ratio of C to a total amount of C and N, satisfy 0.60≤X_{avg}, 0.005≤Y_{avg}≤0.10, 0≤Z_{avg}≤0.005, and 0.605≤X_{avg}+ Y_{avg} ≤0.95, provided that each of X_{avg}, Y_{avg} and Z_{avg} is in atomic ratio,
(b) the complex nitride or carbonitride layer includes at least a phase of Ti, Al and Me complex nitride or carbonitride having a NaCl type face-centered cubic structure,
(c) when crystal orientations of crystal grains of the Ti, Al and Me complex nitride or carbonitride having the NaCl type face-centered cubic structure in the complex nitride or carbonitride layer are analyzed from a vertical cross sectional direction with an electron beam backward scattering diffraction device, inclined angles of normal lines of {111} planes, which are crystal planes of the crystal grains, relative to an direction of a normal line of the surface of the tool body are measured, and an inclined angle frequency distribution is obtained by tallying frequencies present in each section after dividing inclined angles into sections in every 0.25° pitch in a range of 0 to 45° relative to the direction of the normal line among the inclined angles,
a highest peak is present in an inclined angle section in a range of 0° to 12°, a ratio of a sum of frequencies in the range of 0° to 12° to an overall frequency in the inclined angle frequency distribution is 35% or more,
(d) a periodic content ratio change of Ti, Al and Me in the composition formula: (Ti_{1-x-y}AlₓMe_{y})(C_{z}N_{1-z}) exists in the crystal grains of the Ti, Al and Me complex nitride or carbonitride having the NaCl type face-centered cubic structure,
a difference Δx between Xₘₐₓ and Xₘᵢₙ is 0.03 to 0.25, Xₘₐₓ and Xₘᵢₙ being an average value of local maximums of the periodically fluctuating Al content x and an average value of local minimums of the periodically fluctuating Al content x, respectively, and
(e) a period along the direction of the normal line of the surface of the tool body is 3 nm to 100 nm in the crystal grains, in which the periodic content ratio change of Ti, Al and Me exists, having the NaCl type face-centered cubic structure in the complex nitride or carbonitride layer.

2. The surface coated cutting tool according to Claim 1, wherein
in the crystal grains, in which the periodic content ratio change of Ti, Al and Me exists, having the NaCl type face-centered cubic structure in the complex nitride or carbonitride layer,
the periodic content ratio change of Ti, Al and Me is aligned along with an orientation belonging to equivalent crystal orientations expressed by <001> in a cubic crystal grain, a period along the orientation is 3 nm to 100 nm, and a maximum ΔXo of a change of content ratio x of Al in a plane perpendicular to the orientation is 0.01 or less.

3. The surface coated cutting tool according to Claim 1, wherein
in the crystal grains, in which the periodic content ratio change of Ti, Al and Me exists, having the NaCl type face-centered cubic structure in the complex nitride or carbonitride layer,
a region A and a region B exist in the crystal grains; and
a boundary of the region A and region B is formed in a crystal plane belonging to equivalent crystal planes expressed by {110}, wherein
(a) the region A is a region, in which the periodic content ratio change of Ti, Al and Me is aligned along with an orientation belonging to equivalent crystal orientations expressed by <001> in a cubic crystal grain, and in a case where the orientation is defined as an orientation d_{A}, a period along the orientation d_{A} is 3 nm to 30 nm and a maximum ΔXod_{A} of a change of content ratio x of Al in a plane perpendicular to the orientation d_{A} is 0.01 or less, and
(b) the region B is a region, in which the periodic content ratio change of Ti, Al and Me is aligned along with an orientation, which is perpendicular to the orientation d_{A}, belonging to equivalent crystal orientations expressed by <001> in a cubic crystal grain, and in a case where the orientation is defined as an orientation d_{B}, a period along the orientation d_{B} is 3 nm to 30 nm and a maximum ΔXod_{B} of a change of content ratio x of Al in a plane perpendicular to the orientation d_{B} is 0.01 or less.

4. The surface coated cutting tool according to any one of Claims 1 to 3, wherein a lattice constant a of the crystal grains having the NaCl type face-centered cubic structure satisfies a relationship, 0.05a_{TiN}+0.95a_{AlN}≤a≤0.4a_{TiN}+0.6a_{AlN} relative to a lattice constant a_{TiN} of a cubic TiN and a lattice constant a_{AlN} of a cubic AIN, the lattice constant a of the crystal grains having the NaCl type face-centered cubic structure being obtained from X-ray diffraction on the complex nitride or carbonitride layer.

5. The surface coated cutting tool according to any one of Claims 1 to 4, wherein
in a case where the complex nitride or carbonitride layer is observed from the vertical cross sectional direction of the layer, the surface coated cutting tool includes a columnar structure, in which an average grain width W and an average aspect ratio A of the crystal grains of the Ti, Al and Me complex nitride or carbonitride having the NaCl type face-centered cubic structure are 0. 1 µm to 2.0 µm and 2 to 10, respectively.

6. The surface coated cutting tool according to any one of Claims 1 to 4, wherein
an area ratio of the complex nitride or carbonitride having the NaCl type face-centered cubic structure is 70 area% or more in the complex nitride or carbonitride layer.

7. The surface coated cutting tool according to any one of Claims 1 to 6, further comprising a lower layer between the tool body made of any one of tungsten carbide-based cemented carbide, titanium carbonitride-based cermet, and cubic boron nitride-based ultra-high pressure sintered material; and the Ti, Al and Me complex nitride or carbonitride layer, the lower layer comprises a Ti compound layer, which is made of one or more layers selected from a group consisting of a Ti carbide layer; a Ti nitride layer; a Ti carbonitride layer; a Ti oxycarbide layer; and a Ti oxycarbonitride layer, and has an average total layer thickness of 0.1µm to 20 µm.

8. The surface coated cutting tool according to any one of Claims 1 to 7, further comprising an upper layer in an upper part of the complex nitride or carbonitride layer, the upper layer comprises at least an aluminum oxide layer with an average layer thickness of 1 µm to 25 µm.

9. A method of manufacturing the surface coated cutting tool according to any one of Claims 1 to 8, the complex nitride or carbonitride layer is formed by a chemical vapor deposition method, a reaction gas component of which includes at least trimethyl aluminum.
